Europäisches Patentamt

European Patent Office

Office européen des brevets

(19)

(11) Publication number: **0 164 027**
A2

# EUROPEAN PATENT APPLICATION

(12)

(21) Application number: 85106328.9

(22) Date of filing: 23.05.85

(51) Int. Cl.⁴: **H 03 M 13/00**, G 11 B 20/18

(30) Priority: 30.05.84 US 615132

(43) Date of publication of application: 11.12.85
Bulletin 85/50

(84) Designated Contracting States: FR GB

(71) Applicant: Canadian Patents and Development Limited
Société Canadienne des Brevets et d'Exploitation
Limitée, 275 Slater Street, Ottawa Ontario, K1A 0R3 (CA)

(72) Inventor: Mortimer, Brian C., 964 Normandy Crescent,
Ottawa Ontario K2C 0K9 (CA)

(74) Representative: Rottmann, Maximilian R., Hug
Interlizenz AG Alte Zürcherstrasse 49,
CH-8903 Birmensdorf/ZH (CH)

(54) Method and apparatus for coding digital data to permit correction of one or two incorrect data packets (bytes).

(57) A method of, and apparatus for, encoding and decoding a sequence of data bytes to permit correction of bit errors occurring in one byte of the sequence, or two bytes providing that the two incorrect bytes can be identified (for example if the bytes show parity failure). Each data byte of the sequence comprises data bits and one parity check bit. To encode the sequence of data bytes two «Code C» code bytes are determined from the data bytes, according to predetermined relationships, the data bytes and code bytes together forming an encoded data block. Also, there is provided a method of, and apparatus for, encoding and decoding a bundle of data blocks to permit correction of a number bit errors occurring in bytes of the bundle. (Conceptually, the bundle of data blocks comprises a stack of data blocks, one positioned under another to form a two dimensional array of bytes.) Data block bundle encoding consists of separately encoding rows (i.e. horizontal encoding) and columns or pairs of colums (i.e. vertical encoding) of bytes of the bundle array with two «Code C» code bytes.

BUNDLE CODING BYTE ARRANGEMENT COMPRISING ONE CODE BLOCK (i.e. MODE 1 BUNDLE CODING)

## METHOD AND APPARATUS FOR CODING DIGITAL DATA TO PERMIT CORRECTION OF ONE OR TWO INCORRECT DATA PACKETS (BYTES)

This invention is a method and apparatus for encoding and decoding digital data to permit the correction of any number of incorrect data bits occurring in one received data packet (e.g. data byte) of a data block consisting of a sequence of data packets, each data packet consisting of data bits and one parity check bit. In addition, any number of data bit errors occurring in two data packets may be corrected if the two data packets having errors are identified, e.g. if each of the two data packets shows incorrect parity. Both data block and data block bundle coding are provided, the latter permitting error correction of a substantial number of incorrect data packets occurring in the bundle.

In digital data communication systems, a sequence of bits (i.e. a signal representing binary digits) originates from a transmitter and is transmitted through a communications channel to a receiver. (Usually, data bits are grouped into "packets" consisting of a predetermined number of bits. The number commonly chosen, and selected herein, is eight bits, known as a byte.) If the communications channel were perfect, the sequence of bits received at the receiver would be identical to the transmitted data bits. However, communications channels are not perfect and, because of the presence of (electromagnetic) noise and other spurious signals, some of the received data bits may very well not be the same as the transmitted data bits. Accordingly, encoding and decoding devices have been designed to permit the detection and correction of errors occurring in a sequence of received data bits. Such systems determine if some of the bits of the received data bits differ from the transmitted data bits, and thereafter correct the error or errors, as the system permits.

A ("horizontal") data block coding system and apparatus is provided by the present invention and disclosed herein, to permit the detection and correction of one or more data bit errors occurring in any one data byte of a block of data bytes (or, more generally, data packets) or, in any two data bytes of a block of data bytes (again, or, more generally, data packets) providing that the two bytes have incorrect parity and can therefore be identified. Also provided by the present invention, and disclosed herein, is a ("horizontal and vertical") data block bundle coding system and apparatus. A bundle of data blocks, comprising an array of bytes, is formed by "stacking" data blocks one under another. Bundle coding permits the detection and correction of one or more data bit errors occurring in any one data byte or, in any two data bytes (or, more generally, data packets) providing that the two bytes can be identified, of a horizontal or vertical data block of the bundle. The bundle coding system of the present invention permits the full reconstruction of a missing data block of the bundle.

Bit errors occurring in a block of received digital data, in a data communication system, such as the videotex information system, known in Canada as Telidon* (*an official mark of the Government of Canada, Ministry of Communications, for which notice has been given under Section 9(1)(n)(iii) of the Canadian Trade Marks Act) often results in noticeable and unacceptable picture distortion which, in turn, necessitates requesting, at the receiver, retransmission of that data block and waiting for some time interval before the retransmitted data block has received. Both picture distortion and retransmission delays are undesirable and may contribute to user/subscriber dissatisfaction with the data system. Consequently, it is desirable to be able to detect bit errors occurring in a block, or bundle of blocks, of received data packets and to correct the errors at the receiver. Such error correction capability allows the correction of bit errors occurring in a block of data before the errors result in picture distortion and eliminates having to wait for the reception of a retransmitted data block.

Several error correction methods are known, and many different apparatus have been developed for encoding and decoding data blocks to permit the correction of bit errors. For example, there exists a single bit error correction method, denoted the SAB code, which is described in A Class of High Rate Codes for Byte-Oriented Information Systems, I.E.E.E. Transactions on Communications, Vol. COM-31, No. 3, March 1983.

Another example of a coding method which enables the correction of a single bit error occurring in a block of data bytes (or, more generally, data packets) is denoted herein as the "Product Code". This coding method parity encodes a block of data bits horizontally and vertically, adding one byte of redundancy (i.e. non-data byte) to the bits. One parity bit is added to each group of bits to form data bytes of fixed parity (i.e. for horizontal parity encoding), and one parity check byte (i.e. the redundant byte) is added to each block of data bytes (i.e. for vertical parity encoding). The parity check byte or, code byte, is defined such that the sum of all data bytes, and the code byte, equals 00000000 if even parity is selected, or 11111111 if odd parity is selected. Each bit of the code byte sets the parity of the bits of the data bytes arranged vertically in the block of "stacked" data bytes. This coding method is incorporated into the coding method used in the present invention and is discussed further below.

Another example of a coding method which permits the correction of a single bit error in a block of data bits, is denoted herein as the "Carleton Code". The Carleton Code redundant byte is determined algebraically from the data bytes of the data block to be encoded, in a manner similar to the coding method (Code C) used in the present invention. Details of the Carleton Code are described in pending U.S. Application Serial No. 596,397 which is for another invention of the present inventor.

The above examples of coding methods involve one byte of redundancy per block of data bytes and each enables the correction of a <u>single bit</u> error (being either a data or parity bit). The coding method used in the present invention involves two bytes of redundancy per block of data bytes and, preferably, one or two blocks of code bytes of redundancy for bundle coding and enables the correction of up to two incorrect data bytes for each data block. Bundle coding can provide an even greater level of data correction by repetitively decoding a bundle of data blocks. This is because error corrections made during horizontal decoding may enable additional error corrections to be made upon vertical decoding, and vice-versa. That is, horizontal and vertical decoding can be repeated, in cycles, until the desired correction level is attained (for example, until no further corrections are made possible by the current decoding cycle).

A data block encoding and decoding system, suitable for use in a videotex information system, has been developed whereby two code packets (e.g. bytes), each packet comprising bits, are provided, as redundancy, for each block of data packets. Each data packet and code packet is provided with one parity bit. The code used in the present invention is herein denoted Code C. The method of data block coding, used in the present invention, is alternatively referred to herein, as horizontal coding.

In addition to, and expanding upon, the data block coding system, a bundle coding system has been developed whereby data blocks are (conceptually) "stacked" one under another to form an array of data packets. Vertically associated packets of the bundle are encoded, i.e. vertical encoding, with two code packets (e.g. bytes), as redundancy for the data packets of the vertical group, according to Code C. Either one or two code blocks are appended to the data blocks, the data blocks and code blocks forming a bundle. If only one code block of redundancy is selected, two columns of vertically associated data packets (i.e. columns of the bundle array), are encoded together as one vertical data block and the two code packets for the block are appended to the block, one below each column. If two code blocks of redundancy are selected, each column of vertically associated data packets is encoded and the two code packets are appended below the vertical group, one in each code block, the encoded column forming one vertical data block.

The non-parity bits of each code packet (e.g. the least significant bits), are determined according to predetermined algebraic relationships according to Code C, herein defined, between the data packets. Each code packet also contains one parity bit (e.g. the most significant bit) which sets the parity of the code packet to the selected parity of the data packets. If the parity bits of the data packets are to be included in the determination of the code packets the code packets are not allocated a parity bit and, therefore, are not parity encoded.

The Code C method of encoding enables the correction of bit errors occurring in one data packet of a block of data, or two packets if the packets can be identified. Bundle coding utilizes Code C to encode data blocks arranged in a "bundle" to form an array of packets, each vertical and horizontal block of packets being encoded according to Code C. Bundle coding permits the correction of a greater number of error packets than data block encoding alone enables. For example, one lost data block of a bundle can be completely reconstructed using bundle coding, providing that the arrangement of error packets in the bundle conforms to the (known) limitations of the coding method.

Before providing a summary of the invention, it will be helpful, to ensure consistency, to define some of the terminology employed in the disclosure and claims.

1.        A "bit" is a binary digit and has one or other of two values, for example, a bit may be either 0 or 1.

2.        A "data packet" is a sequence of a fixed number of bits. The well-known term "byte" is a data packet having 8 bits and is selected for the system herein disclosed. Equally, with some straightforward modification of the methods and apparatus herein disclosed, a data packet could be selected having, for example, 5, 9, 16 or 87 bits. (A word of caution is in order; the term "packet" is used herein according to the definition above and does not mean, or have any relationship to, the 33 byte packet used in the Telidon* nomenclature.)

3.  A block of data packets is a sequence of a fixed number of data packets. For the system described herein, a packet is a byte and each block of data packets, or, in the case of bundle coding, each horizontal block of data packets, consists of 28 bytes, 26 bytes being data bytes and 2 bytes being code bytes comprising one code word.

4.  A bundle of data blocks consists of a fixed number of data blocks. For convenience, and to facilitate understanding of the bundle coding method used in the present invention, a bundle of data blocks may be visualized conceptually as a stack of data blocks, arranged one under another, the packets of each block aligned so as to form an array of packets. Data blocks so stacked are herein referred to as rows of the bundle or, alternatively, as horizontal data blocks. The columns of packets of the array to be encoded are herein referred to as columns of the bundle, or, alternatively, as vertical data blocks. For the system herein disclosed, a data block bundle consists of h (horizontal) data blocks i.e. h rows. In one embodiment of the present invention for bundle coding, the hth data block consists wholly of code bytes for the columns of bytes of the bundle. In another embodiment of the present invention, also for bundle coding, the h-1th and hth data blocks both consist wholly of code bytes for the columns of bytes of the bundle.

5. A parity check bit is an extra (i.e. redundant) bit, placed at a predetermined location in a sequence of bits, for example in a byte, and is used for error detection. Suppose that a sequence of 7 bits are to be parity encoded, with one parity bit, to form a parity encoded data byte. To do so, a parity bit is appended to the 7 data bits, the value of the parity bit being determined by the desired number of 1's in the byte. As an example, if it is desired that all data bytes have an odd number of 1's, (i.e. if odd parity is desired), the parity check bit is set to 0 or 1, depending upon the number of 1 data bits. The parity check bit is 0 if there are an odd number of 1 data bits, and 1 if there are an even number of 1 data bits. Thus, a parity encoded data byte consists of 7 data bits and 1 parity check bit. Inclusion of a parity check bit permits the identification of a received packet (e.g. byte) having an odd number of bit errors, since an odd number of bit value changes occurring in a packet necessarily changes the parity of the packet. However, a parity check bit does not permit identification of the specific bits which are received in error. A greater degree of redundancy than 1 bit per byte, is required to be able to do so.

6. A "codeword", referred to herein, consists of 2 code bytes (or, more generally, packets) determined algebraically, according to predetermined relationships between data bytes which define Code C, as disclosed herein. In the system described herein, the data bytes of a data block or, in the case of bundle coding, the data bytes of a horizontal or vertical data block, determine one codeword. Therefore, each encoded data block contains one codeword.

7. "Binary addition" (or, simply "addition") referred to herein, means addition by modulo 2 arithmetic. By modulo 2 addition, $1+1=0$; $0+0=0$; $1+0=1$ and $0+1=1$. The logic function denoted "exclusive OR" effects the same operation as modulo 2 addition. For example, if two bytes, namely, 11111111 and 01010101 are added together, using binary addition, or exclusive OR'ed, the result is 10101010.

The present invention provides a data block encoding device to encode a sequence of parity encoded data packets with two code packets (i.e. with a Code C codeword) to permit the detection and correction of one incorrect packet occurring therein, or two incorrect packets if the two packets are identifiable. The device comprises identification means to identify data packets of a data block, each packet containing one parity check bit, and processing means for producing two code packets. The code packets are defined such that the sum, using modulo 2 addition, of the data packets and code packets is equal to zero and the sum of the data packets and code packets each multiplied by a particular packet representative of a unique Galois field element, is equal to zero.

The processing means includes summing means to sum, by modulo 2 addition, two packets. Multiplication means are also included for multiplying two packets together, each packet being representative of a Galois field element. Multiplication occurs within the particular Galois field over the Galois field of two elements, namely, 0 and 1. The processing means also includes generating means for producing two code packets conforming to the summations defined above and assembly means for assembling the code packets with data packets to produce an encoded data block comprising data packets and two code packets (i.e. Code C codeword).

Preferably the processing means includes a microprocessor and appropriate operating system, contained in memory, to control the microprocessor and process the data packets.

Also provided by the present invention is a data block decoding device to decode a sequence of packets of a data block, the packets encoded with two code packets (i.e. a Code C codeword), to detect incorrect packets occurring in the block and correct one or two incorrect packets (providing that the two incorrect packets can each be identified). The device comprises identification means to identify packets of the data block and processing means for producing one or two bit-error-pattern packets according to predetermined relationships between the packets of the data block. The processing means includes parity check means to determine the parity of each of the data packets of the data block. Also included is byte parity error flagging means to permit the identification of two bytes having parity failure. Summing means, by modulo 2 addition, and multiplication means are included to determine, according to predetermined relationships between the packets, one bit-error-pattern packet for one incorrect packet or two bit-error-pattern packets for two identified incorrect packets. The multiplication occurs within the particular Galois field which contains elements capable of representation by the packets, over the Galois field of two elements, namely, 0 and 1. The decoding device also comprises packet correction means to correct incorrect packets with the bit-error-pattern packets.

Preferably the processing means of the decoding device includes a microprocessor and appropriate operating system, contained in memory, to control the microprocessor and process the data and code packets.

The invention is described, by way of example, with reference to the following drawings.

Figure 1 illustrates, by way of pictorial representation, the arrangement of data bytes and code bytes forming an encoded data block bundle, the bundle comprising encoded data blocks and one code block.

Figure 2 illustrates, by way of pictorial representation, the arrangement of data bytes and code bytes forming an encoded data block bundle, the bundle comprising encoded data blocks and two code blocks.

Figures 3a and 3b (collectively referred to herein as "Figure 3") illustrates, in flowchart form, a process for encoding a number of data bytes with two code bytes according to Code C, to form an encoded data block.

Figures 4a, 4b, 4c, 4d and 4e (collectively referred to herein as "Figure 4") illustrates, in flowchart form, a process for decoding an encoded data block having two Code C code bytes, and correcting one or two incorrect bytes of the block, as permitted.

Figures 5a and 5b (collectively referred to herein as "Figure 5") illustrates, in flowchart form, a process for encoding a bundle of data blocks with one code block, the arrangement of bytes of the bundle, for coding, being the arrangement of Figure 1.

Figure 6 illustrates, in flowchart form, a process for encoding a bundle of data blocks with two code blocks, the arrangement of bytes of the bundle, for coding, being the arrangement of Figure 2.

Figure 7 illustrates, in flowchart form, a process for decoding a bundle of data blocks encoded, according to Code C, with one code block, and correcting incorrect bytes of the bundle as permitted.

Figure 8 illustrates, in flowchart form, a process for decoding a bundle of data blocks encoded, according to Code C, with two code blocks, and correcting incorrect bytes of the bundle as permitted.

The coding method utilized in the present invention, denoted Code C, involves a two byte (or, more generally, a two packet) codeword for redundancy. The invention and coding method are described herein, by way of example only, with respect to an embodiment thereof in which 26 data bytes are encoded to form a data block of 28 bytes, 2 bytes being code bytes determined according to Code C comprising one codeword. However, it should be recognized that the coding method utilized is general, and not specific, and the embodiment disclosed herein might be modified by one having average skill in the art, so as to apply to data packets comprising some number of bits other than 8 and/or to data blocks comprising some number of packets other than 28. The invention will now be described, by way of example only, considering data blocks consisting of 26 data bytes and 2 code bytes.

By "redundancy" (mentioned above), it is meant that the codeword does not add to the data bytes information which is intended to be received for use by an end-user. Rather, the added codeword is dependent upon, and derived from, the data bytes (the data bytes containing information intended for an end-user), and it is the resultant redundancy of information which enables the correction of errors occurring in the data bytes. The greater the number of bits of redundancy, added to the data bytes, the greater the scope will be for the
correction of errors occurring in the data bits.  The error
correction codewords, used in the present invention, enable the
accuracy of received data bytes to be improved without the
necessity of retransmitting correct data.

The.bits of the two bytes of a Code C codeword are
defined appropriately to satisfy two conditions defined by
algebraic combinations of the data bytes and code bytes of a
data block.  The first condition corresponds to the condition
defining the Product Code, mentioned above, which requires that
the addition of all bytes of an encoded data block produces an
all-0 or all-1 result, depending upon the parity selected.  The
second condition is similar, in form, to the relationship
defining a code byte of the Carleton Code, mentioned above.
The Carleton Code and Code C both involve the representation of
data bytes as elements of a particular finite field in order
that the bytes may be manipulated according to the particular
algebraic relationships defining the code while the result
remains in the finite field.  Given this introduction to the
method of data coding, denoted Code C, a more detailed
description of same follows.

As mentioned above, the coding method used in the
present invention, denoted herein Code C, is a two byte
redundancy code.  The two byte codeword, for a group of data
bytes is defined by two independent conditions.  The first can be described simply and involves setting to zero the binary sum of data and code bytes.  The second is less simply described and involves letting the data and code bytes be representative of elements of a finite field, namely, a Galois field, in order that those bytes may be algebraically manipulated within the field according to particular algebraic relationships.

Consider that $N-2$ data bytes, denoted $B_0$, $B_1$, ... $B_{N-4}$, $B_{N-3}$, are to be encoded with two code bytes, denoted $B_{N-2}$ and $B_{N-1}$, to form a data block of $N$ bytes encoded according to Code C.  In the embodiment herein disclosed, N equals 28.  Also, in the embodiment herein disclosed, the byte parity selected is odd parity.  Accordingly data bytes $B_0$ to $B_{N-3}$ each contain 7 data bits plus one added redundant bit for setting the parity of the byte to odd parity.  For example, denoting the first seven data bits of $B_0$, $b_{0,1}$, $b_{0,2}$, ... $b_{0,7}$, the bit $b_{0,8}$ is selected as the parity bit for byte $B_0$, the value of which is determined so as to set the parity of byte $B_0$ to odd parity.  The parity of each code byte is also set to the selected parity, viz. odd parity.

A description of each of the aforementioned two conditions, which define, according to Code C, the two code bytes, $B_{N-2}$ and $B_{N-1}$, follows.

(i)    <u>The first condition, of two, which defines the bytes of a Code C codeword:</u>

By the first condition defining a Code C codeword, the binary sum (i.e. modulo 2 arithmetic) of all bytes in the data block is set to zero (i.e. 00000000). This may be expressed mathematically by the following:

$$\sum_{i=0}^{N-1} B_i = B_0 + B_1 + \ldots + B_{N-2} + B_{N-1} = 0 \quad \text{------(1)}$$

It will be noted that the above sum sets the vertical bit parity of the bytes to even parity since the sum of each set of vertically grouped bits is set to zero. The terms "vertical parity" and "vertically grouped bits" referring to the bit groups $b_{0,1} + \ldots + b_{N-1,1}$; $b_{0,2} + \ldots + b_{N-1,2}$, etc.) To appreciate the reason for referring to "vertical" bits, visualize, for example, bytes $b_0, \ldots, b_{N-1}$, stacked one under another to form an array of bits of array size N rows x 8 columns. The sum defined by (1) above, requires that the parity of each column of bits is even, since the sum of all bits in a column is equal to zero. That is, the number of 1's in a column is required to be an even number. In fact, the parity selected for the embodiment herein disclosed is odd parity; therefore, the sum defined by (1) above, is really determined to equal 11111111. That is, if each column of bits, $b_{0,1}, \ldots b_{N-1,1}$; $b_{0,2}, \ldots, b_{N-1,2}$; etc., contains an odd number of 1's, then the sum of bits in each column equals 1.

The parity bits of data bytes $B_0, \ldots B_{N-1}$, i.e. $b_{0,8}, \ldots b_{N-1,8}$, are excluded from the definition of the conditions which define the code bytes $B_{N-2}$ and $B_{N-1}$ if the code bytes are desired to be parity encoded. The reason for the exclusion of the parity bits of data bytes, is that the seven data bits are let to represent a Galois field element of $GF(2^7)$ and the code bytes, derived from the data bits, also represent an element of the Galois field. Thus, the code bits so derived comprise seven bits which leaves one bit for a parity check bit to form parity encoded code bytes. If eight bit Galois field elements are selected, the data bytes and code bytes, being representative of elements in the Galois field, each comprise eight bits and, therefore, the eight derived code bits cannot be easily parity encoded, the eighth bit already being used. This will become apparent from the discussion below pertaining to the relationship of Galois fields and the method of determination of the code bytes $B_{N-2}$ and $B_{N-1}$, in accordance with the present invention.

(ii)    The second condition, of two, which defines the bytes of a Code C codeword;

The second condition defining the Code C codeword, operates within a cyclic field of finite elements, selected herein as a Galois field of 128 elements. The condition is algeabraically defined under the finite field and each element of the selected field may be represented by seven bits which, in turn, can be parity encoded to form a byte by adding on parity check bit. Accordingly, by letting the data bits of data bytes represent field elements, multiplication and addition of the 7 data bits of data bytes can be performed within the field while the results of those operations remain within the field which means that they too can be represented by 7 bits. Therefore, arithmetic may effectively be performed, according to known rules of finite field arithmetic, on the data bits since the data bits represent field elements.

Galois field theory is well-known in the art of mathematics and, more specifically, in the art of information and coding theory. The textbook "An Introduction to Error Correcting Codes" by Shu Lin, published by Prentice-Hall, might be referred to for a relatively easy-to-understand description of Galois fields. For a more advanced discussion, the textbook "Information Theory & Reliable Communication", by R.G. Gallagher, published by McGraw-Hill, might also be referred to. Also, patent application Serial No. 596,397, for an invention of the present inventor, describes in considerable detail many aspects of Galois field theory which are relevant to this invention. In view of the fact of the textbooks identified above, and many others which are publicly available, a detailed description of Galois field theory is not included herein. A summary description thereof, follows.

Galois Fields

The Galois field $GF(2^7)$ of 128 elements, including zero, is selected for the embodiment of the present invention disclosed herein. This field is selected because data bytes comprising seven data bits and one parity check bit are desired to be encoded and, it is desired that the codeword also comprise parity encoded bytes. Accordingly, it is appropriate to select a Galois field comprising elements which are capable of being represented by 7 bits in order that two 7 bit codes may be derived from the data bits and each code can then be encoded with a parity bit to form parity encoded code bytes.

However, the disadvantage of choosing 7 bit field elements (i.e. of $GF(2^7)$) is that only the data bits of data bytes are encoded for error detection and correction, the parity bit being excluded from the calculation of the code bytes. As an alternative, if this is unacceptable, a Galois field of 256 elements, (i.e. $GF(2^8)$) might be selected. Elements of $GF(2^8)$ may be represented by eight bits and, accordingly, each data byte, including the parity bit, could then represent a field element. Again, though, there is a disadvantage associated with using the field $GF(2^8)$ instead of the field $GF(2^7)$; if the field $GF(2^8)$ is selected, the code bytes can not be conveniently encoded for parity and, therefore, not all bytes of the encoded data block are conveniently encoded for parity. This means that an odd number of bit errors occurring in the code bytes cannot be detected through parity checking.

To illustrate the above, the form of the Galois field $GF(2^7)$ will now be discussed briefly. The primitive polynomial $X^7+X^3+1$, of degree seven, is selected and $\alpha$ is defined as a root of this polynomial. Therefore, $\alpha^7 + \alpha^3+1=0$ and, if we select coefficients in $GF(2)$ comprising the elements 0 and 1, then modulo 2 arithmetic applies and $\alpha^7 = \alpha^3+1$. The non-zero elements of $GF(2^7)$

are $\alpha^0, \alpha^1, \alpha^2, \ldots \alpha^{126}$. The field is cyclic

and, therefore, $\alpha^{127}=1$. It is known that the first seven

powers of $\alpha$ (i.e. $\alpha^0, \alpha^1, \alpha^2, \alpha^3, \alpha^4, \alpha^5, \alpha^6$),

called the basis elements, are linearly independent over GF(2) and that every element of GF($2^7$) may be written as a sum of the basis elements. For example, the element $\alpha^2$ may

be written as $0 \cdot \alpha^0 + 0 \cdot \alpha^1 + 1 \cdot \alpha^2 + 0 \cdot \alpha^3$

$+0 \cdot \alpha^4 + 0 \cdot \alpha^5 + 0 \cdot \alpha^6$ which in turn can be represented simply by the coefficients of the polynomial as 0010000 (i.e. in the form of a 7 bit number). To generate $\alpha^8$ in 7

bit form, recall that $\alpha^8 = \alpha(\alpha^7) = \alpha(\alpha^3+1) = \alpha^4 + \alpha$.

Therefore, $\alpha^8$ equals $0 \cdot \alpha^0 + 1 \cdot \alpha^1 + 0 \cdot \alpha^2 + 0 \cdot$

$\alpha^3 + 1 \cdot \alpha^4 + 0 \cdot \alpha^5 + 0 \cdot \alpha^6$ which can be represented by the coefficients of the polynomial as 0100100. The 7 bit representation of elements of higher orders of $\alpha$ can be

generated in a similar manner.

The elements of GF($2^8$) can be defined with respect to the primitive polynomial $1+x^2+x^3+x^4+x^8$ of degree

eight, and the 8 bit representation of the elements can be formulated in a manner similar to the above. For greater detail, reference may be made to the aforementioned textbooks.

The arithmetic operations addition (which is the same as subtraction under modulo 2 arithmetic since 1+1=0, i.e. 1=-1) and, multiplication and division are defined under a Galois field (e.g. GF($2^7$) and GF($2^8$)) comprising a finite

number of elements. That is, two elements of a Galois field, when added, multiplied or divided, will result in an element of that Galois field. Addition is conveniently performed in using the bit representation of field elements, while multiplication and division are conveniently performed using the exponential form of representation of field elements. For example, consider elements $\alpha^2=0010000$ and $\alpha^8=0100100$ of $GF(2^7)$. To add these numbers, it is easiest to add, using modulo 2 arithmetic, the two elements as follows:

$$\begin{array}{c} 0010000 \\ 0100100 \\ \hline 0110100 \end{array}$$

The 7 bit number 0110100 represents the element $\alpha^{16}$ (which can be verified easily using Galois field theory and/or the above illustration for finding the representation of $\alpha^8$). Thus, $\alpha^2+\alpha^8=\alpha^{16}$.

To multiply or divide the two elements, it is easiest to use the exponential form of the elements as follows:
$\alpha^2 \cdot \alpha^8 = \alpha^{2+8} = \alpha^{10}$ and,
$\alpha^2 / \alpha^8 = \alpha^{2-8} = \alpha^{-6} = 1/\alpha^6 = \alpha^{127}/\alpha^6 =$
$\alpha^{127-6} = \alpha^{121}$.

Both $\alpha^{10}$ and $\alpha^{121}$ may be represented by 7 bits as described above. Note that, since $\alpha^{127}$ equals 1, $\alpha^{127+X}$ equals $\alpha^X$.

Since the data bits of the data bytes comprise 7 bits, the data bits of a data byte may be treated as a Galois field element of $GF(2^7)$ and therefore the data bits of bytes may be added and multiplied either together or with selected field elements, in accordance with the principles of Galois field arithmetic illustrated above. Similarly, if all bits (i.e. the data bits and the parity bit) of the data bytes are desired to be encoded, and the Galois field $GF(2^8)$ is selected, all bits (i.e. 8 bits) of each data byte may be treated as an element of $GF(2^8)$ and therefore the data bytes may be added and multiplied either together or with selected elements of $GF(2^8)$, in accordance with the principles of Galois field arithmetic illustrated above.

Note that if finite field arithmetic is not employed and data bits (or data bytes) are not let to represent elements of a finite field, arithmetic manipulation of the data bits (or data bytes) would not necessarily result in 7 bit (or 8 bit) numbers as desired. For example, the 7 bit real number 1111111, representing in binary notation the real (infinite field) number 127, when multiplied by the 7 bit real number 0100000, representing in binary notation the real number 2, equals the real number 254 (in decimal notation). More than 7 bits are required to represent the real number 254 using binary notation, the real number 254 being represented in binary notation by the eight bits 01111111 (going from least significant to most significant bit).

The second condition of Code C is defined by the following sum, where $B_0$ to $B_{N-1}$ are as defined above, $B_{N-2}$ and $B_{N-1}$ comprising the code bytes of the Code C codeword.

$$\sum_{i=0}^{N-1} B_i \alpha^i = B_0 + B_1 \alpha^1 + \ldots + B_{N-1} \alpha^{N-1} = 0 \text{---} (2)$$

Encoding: Selection of Code Bytes:

From conditions (1) and (2) defined above, the bytes of the codeword, $B_{N-2}$ and $B_{N-1}$, may be defined. That is, we have two unknowns in two equations and therefore the unknowns can be solved for. The following solution was selected, for convenience, for use in the embodiment of the present invention herein disclosed: However, it should be recognized that given conditions (1) and (2) above, the value of the code bytes $B_{N-2}$ and $B_{N-1}$ is uniquely defined and all valid expressions derived from conditions (1) and (2) defining the code bytes, are equivalent. (That is, all such expressions result in identical code bytes.) Accordingly, several other derivations of relationships, defining the code bytes, apart from those provided below and used herein, might be selected for use in the present invention, the preferred relationship depending upon, inter alia, personal preference and the type of electronic devices selected to implement this invention.

Recall that if, for example, $GF(2^7)$ is selected, then $\alpha^{-1} = \alpha^{127} \cdot \alpha^{-1} = \alpha^{127-1} = \alpha^{126}$. Of course, $\alpha^{126}$, being an element of $GF(2^7)$ has a unique 7 bit representation. For convenience, let $\gamma = \alpha^{-1}$. Then, by dividing both sides of equation (1) by $\alpha^{N-1}$ condition (2) above can be written as follows:

$$B_0\gamma^{N-1} + B_1\gamma^{N-2} + \ldots + B_{N-2}\gamma + B_{N-1} = 0 \text{----}(3)$$

Thus from relationships (1) and (3) above,

$$B_{N-2} + B_{N-1} = B_0 + B_1 + \ldots + B_{N-3} \text{ and,}$$

$$B_{N-2}\gamma + B_{N-1} = B_0\gamma^{N-1} + B_1\gamma^{N-2} + \ldots + B_{N-3}\gamma^2$$

$$= \gamma^2[B_0\gamma^{N-3} + B_1\gamma^{N-4} + \ldots + B_{N-3}]$$

If we let $\delta = B_0 + B_1 + \ldots + B_{N-3}$ ----------(4)

and, $\gamma = B_0\gamma^{N-3} + B_1\gamma^{N-4} + \ldots + B_{N-3}$ ---(5)

Then, $B_{N-2} + B_{N-1} = \delta$ -----------(6)

and, $B_{N-2} + B_{N-1} = \gamma\gamma^2$ --------(7)

The code bytes $B_{N-2}$ and $B_{N-1}$ may be derived from the expressions (6) and (7) above, with the following results:

$$B_{N-2} = (\delta + \gamma\gamma^2)/(1+\gamma) = (\delta + \gamma\gamma^2)\gamma 30, --------------(8)$$

since $1/(1+\gamma) = \gamma^{30}$

$$B_{N-1} = \delta + B_{N-2} ---------------------------------(9)$$

It will be apparent to the reader that the values $\delta$

and $\gamma$ are determined from the data bytes $B_0$ to $B_{N-3}$

which are to be encoded. Therefore, the code bytes $B_{N-2}$

and $B_{N-1}$ are determined algebraically from the data bytes

within $GF(2^7)$ (or $GF(2^8)$) according to relationships (8) and (9) above.

If $GF(2^7)$ is selected, only the data bits of data

bytes $B_0$ to $B_{N-3}$ are considered in the above

relationships and, $\alpha$ equal to $\gamma^{-1}$ is an element of

$GF(2^7)$ capable of representation by 7 bits. The code bytes

$B_{N-2}$ and $B_{N-1}$ are therefore also elements of $GF(2^7)$

and each comprises 7 code bits plus one parity check bit. The parity check bit is the eighth bit of each code byte and is determined according to the selected parity. For example, if odd parity is selected and there are an odd number of 1's in the seven bit representation of the field element determined according to relationship (8) or (9) above, then the 8th bit is set to zero so that the code byte has odd parity. Conversely, if there is an even number of 1's, the 8th bit is set to 1 to produce an odd parity code byte.

If $GF(2^8)$ is selected, all of the bits i.e. data bits and parity bit, of data bytes $B_0$ to $B_{N-3}$ are considered in the above relationships, and $\alpha$ equal to $\gamma^{-1}$ is an element of $GF(2^8)$ capable of representation by 8 bits. The code bytes $B_{N-2}$ and $B_{N-1}$ are, therefore, also elements of $GF(2^8)$ and may be represented by 8 bits. Accordingly, there is not then an unused bit which can be conveniently used to set the parity of the code bytes, all 8 bits of the code byte being defined by conditions (1) and (2) above. Therefore, if all of the bits of data bytes $B_0$ to $B_{N-3}$ are encoded according to Code C, the code bytes are not conveniently parity encoded.

Decoding according to Code C:

If bytes $B_0$ to $B_{N-1}$, comprising one data block, satisfy condition (1) and (2) defined above, a bit error pattern, denoted $e_j$, occurring in byte $B_j$, or bit error patterns, denoted $e_j$ and $e_k$, occurring in two bytes $B_j$ and $B_k$ providing that j and k are known (for $0 \le j, k \le N-1$), can be determined and the incorrect bytes can therefore be corrected.

The first case of application of Code C is where one byte, denoted $B_j$ is received with one or more bits in error.

If we denote the error pattern of bits $e_j$, the summations of conditions (1) and (2) above occur as follows:

$$B_0+\ldots+B_j+e_j+\ldots+B_{N-1}=0+e_j \quad\text{------------}(10)$$

$$B_0+\ldots+(B_j+e_j)\alpha^j+\ldots+B_{N-1}\alpha^{N-1}=0+e_j\alpha^j\text{----}(11)$$

Therefore, if we write the received bytes $B_0$ to $B_{N-1}$ as $B_0'$ to $B_{N-1}'$, then:

$$R_1 \overset{\Delta}{=} \sum_{i=0}^{N-1} B_i'=e_j \quad\text{------------------------}(12) \text{ and,}$$

$$R_2=\sum_{i=0}^{N-1} B_i'\alpha^i=e_j\alpha^j \quad\text{----------------------}(13)$$

From relationships (12) and (13) above, it is apparent that the incorrect byte $B_j$, having a bit error pattern $e_j$, may be identified by determining the value $j$, according to the following:

$$j=\log_\alpha(R_2/R_1)=\log_\alpha(e_j\alpha^j/e_j)=\log_\alpha(\alpha^j)\text{--------}(14)$$

Thus, if one byte of the data block is received in error, the incorrect byte (viz. the _j_th byte, denoted $B_j$) and the incorrect bits of that byte which are identified by the bit error pattern $e_j$, may be determined according to the above and thereafter corrected by adding the error pattern $e_j$ to the identified incorrect byte $B_j$. In the case where only one byte $B_j$ of a block is received with bit errors the incorrect byte $B_j$ can be identified (i.e. by the value $j$) and corrected (i.e. using the bit error pattern $e_j$) whether or not the byte has incorrect parity.

Since the value j is represented by a maximum of seven bits, in the case where the Galois Field $GF(2^7)$ is selected, or eight bits, in the case where the Galois Field $GF(2^8)$ is selected, the range of values possible for j is 0 to 127 or 0 to 255, respectively. Therefore a maximum of 128 or 256 bytes (or packets) may comprise one data block where the block is coded according to Code C, depending upon whether the Galois Field $GF(2^7)$ or $GF(2^8)$, respectively, is selected.

To correct byte $B_j$, the error pattern $e_j$ determined according to the above, is added to received byte $B_j'$. For example, consider that the second and third bits of byte $B_j$ are received in error. Then error pattern $e_j$ equals 0110000, if $GF(2^7)$ is selected, or 01100000, if $GF(2^8)$ is selected. By adding $e_j$ to the received byte $B_j'$ the incorrect bits will be changed and therefore corrected since modulo 2 addition is used.

The second case of application of Code C is where two bytes denoted $B_j$ and $B_k$ are received with one or more bits in error. If we denote the bit error patterns for those bytes, $e_j$ and $e_k$, respectively, the summations of conditions (1) and (2) above occur as follows:

$$B_0 + \ldots + B_j + e_j + \ldots + B_k + e_k + \ldots + B_{N-1} = 0 + e_j + e_k \text{----------------- (15)}$$

$$B_0 + \ldots + (B_j + e_j)\alpha^j + \ldots + (B_k + e_k)\alpha^k + \ldots + B_{N-1}\alpha^{N-1} = 0 + e_j\alpha^j + e_k\alpha^k \text{-- (16)}$$

Therefore, if we write the received bytes $B_0$ to $B_{N-1}$ as $B_0'$ to $B_{N-1}'$ then:

$$R_1 \overset{\triangle}{=} \sum_{i=0}^{N-1} B_i' = e_j + e_k \quad \text{---------------(15a)}$$

and

$$R_2 \overset{\triangle}{=} \sum_{i=0}^{N-1} B_i' \alpha^i = e_j \alpha^i + e_k \alpha^k \quad \text{----------(16a)}$$

If j and k are known (i.e. if the incorrect bytes are identifiable, for example, by showing parity failure) expressions (15a) and (16a) above enable the solution of the bit error patterns $e_j$ and $e_k$ since two unknowns occurring in two independent expressions can be determined through solution of the expressions.

Again, as stated above, with respect to encoding, various expressions of the solution of $e_j$ and $e_k$ might be selected. The following derivations and resulting relationships have been selected herein for convenience only and the present invention is not intended to be limited to embodiments which utilize these expressions. It will be recognized that there are an unlimited number of ways to equivalently express any particular algebraic relationship and that it is the conditions defining the derived relationships which are unique. Here it is the conditions defined by (1) and (2) above which are unique.

Assume that code bytes $B_{N-2}$ and $B_{N-1}$ have been determined according to relationships (8) and (9) above and that data byte $B_j$ is received with the error pattern $e_j$. Then:

$$\delta' = B_0 + \ldots + B_j + e_j + + B_{N-1} = 0 + e_j \quad \text{---------(17)}$$

and,

$$\Upsilon' = B_0 \gamma^{N-1} + \ldots + (B_j + e_j)\gamma^{N-1-j} + \ldots + B_{N-1} =$$
$$0 + e_j \gamma^{N-1-j} \text{------------------(18)}$$

Thus, the incorrect received byte $B_j$ may be corrected by adding the bit error pattern defined by $\delta'$ (above) to the byte $B_j$. Also, the number $j$ of the byte may be determined according to (14) above if the byte $B_j$ cannot be identified through parity failure.

Now assume that two incorrect data bytes, denoted $B_j$ and $B_k$, are received in error. Then:

$$\delta' = e_j + e_k \text{---------------------------(19)}$$
$$\Upsilon' = e_j \gamma^{N-1-j} + e_k \gamma^{N-1-k} \text{-------------(20)}$$

where, $\delta'$ and $\Upsilon'$ are defined by (17) and (18) above.

If the values $j$ and $k$ are known, the bit error patterns $e_j$ and $e_k$ are added to the received incorrect bytes $B_j$ and $B_k$, respectively, to correct the bytes. From relationships (19) and (20) above, the bit error patterns $e_j$ and $e_k$ may be determined from the following:

$$e_j = (\delta' \gamma^{N-1-k} + \Upsilon')/(\gamma^{N-1-j} + \gamma^{N-1-k}) \text{----(21)}$$
$$e_k = \delta' + e_j \text{----------------------------(22)}$$

Note that, if the Galois field $GF(2^7)$ is selected, error patterns $e_j$ and $e_k$ comprise 7 bits only and permit the correction of <u>data</u> bits of bytes $B_j$ and $B_k$ only. If the Galois field $GF(2^8)$ is selected, the bit error patterns

$e_j$ and $e_k$ comprise 8 bits each and permit the correction of all bits, (i.e. data bits and parity bit) of bytes $B_j$ and $B_k$.

The above completes the description of the method of coding a block of data bytes according to Code C. A bundle arrangement of data blocks, encoded according to the above, may be selected in accordance with the present invention, and each vertical data block encoded with a Code C codeword to permit the correction of a greater number of bytes than is permitted by data block coding alone. The following is a description of the bundle coding method used in the present invention.

Bundle Coding Using Code C:

Bundle coding refers herein to a coding process whereby data blocks are encoded according to the above and thereafter arranged in a bundle for vertical encoding. A bundle comprises a number of encoded data blocks "stacked" (conceptually) one under another, the bytes of each block aligned to form an array of bytes. The encoded data blocks, denoted herein as horizontal data blocks, form rows of the array. To encode the bundle, the columns of the bundle array of bytes are encoded with two Code C code bytes according to the above described method, forming encoded vertical data blocks. Thus, bundle coding involves an array of data bytes, each row encoded horizontally with a Code C codeword, and each column (or group of two columns), encoded vertically with a Code C codeword.

As stated above, the selected size of data blocks for the description herein is 26 data bytes and two code bytes. The number of data blocks in one bundle is denoted herein as h data blocks.

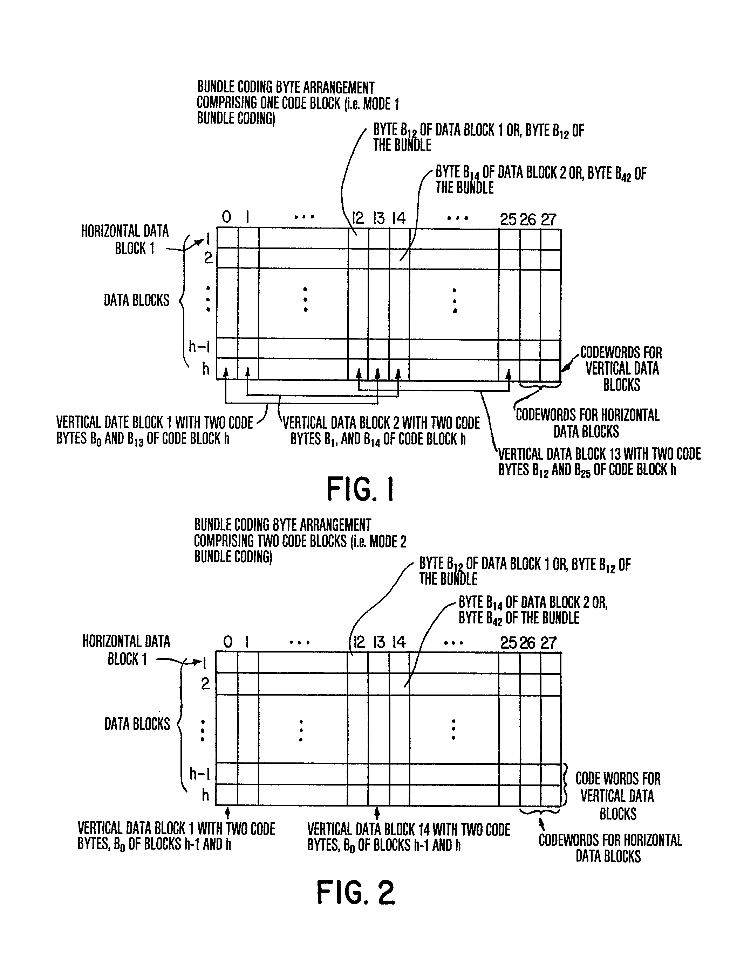

Figure 1 of the drawings shows one arrangement for the data blocks of a bundle. The bundle comprises an array of bytes as illustrated. The coding format of Figure 1, for coding columns of the bundle, includes one code block, denoted block h.

To encode a bundle of encoded data blocks, using one block of codewords, two columns of bytes of the bundle of data blocks are encoded together forming one vertical data block. Each byte of the two byte Code C codeword for a vertical data block is positioned in an appended code block (i.e. block h), one code byte positioned below each of the two columns of the vertical data block. It is preferable to stagger, to the extent possible, the two columns of each vertical data block because noise bursts are likely to cause errors in consecutive bytes of a (horizontal) data block during transmission each (horizontal) data block of the bundle being transmitted one after the other. By encoding staggered columns, non-consecutive bytes of each data block are encoded together and this increases the probability that fewer bytes containing errors will occur in each vertical data block and, as a result, the probability that more than two incorrect bytes will be received in a vertical data block decreases. In turn, the probability of error detection and correction increases.

In the present embodiment, bundle columns are staggered by one half the number of data bytes per data block i.e. by 13 columns. Therefore, the first vertical data block comprises the first byte of each data block in the bundle and the fourteenth byte of each data block in the bundle. The second vertical data block comprises the second and fifteenth bytes of each data block in the bundle, and so on, to the last vertical data block which comprises the thirteenth and twenty-sixth bytes of each data block in the bundle.

The data bytes of each vertical data block are encoded according to Code C, described above, with two code bytes for each vertical data block. One code byte is appended to each column of the vertical data block. Each vertical data block is encoded in like manner and, therefore, one code byte is produced for each column of data bytes of the bundle for a total of $N-2$ code bytes, where $N$ is the number of bytes in an encoded data block (i.e. herein selected as 28). The vertical code bytes comprise a code block, being block h in Figure 1. The last two bytes of the code block may comprise a Code C codeword for either the code block or the vertical block comprising the last two columns of the bundle. Preferably the last two bytes of the code block are Code C code bytes for the code block. By this choice both data and code blocks are encoded in like manner and each can be decoded, according to the above, in like manner as the block is received. When the bundle of data blocks has been received the vertical data blocks are decoded to complete the decoding of the bundle.

Figure 2 illustrates a bundle coding format which utilizes two code blocks, denoted blocks h-1 and h.  If two code blocks are used to encode a bundle of data blocks it is not necessary to include more than one column of the bundle array in each vertical data block because the two code bytes for the vertical data block can each be positioned in separate code blocks viz. blocks h-1 and h.  For example, the first column of the bundle may comprise the first vertical data block, the bytes of the codeword for the block being the first bytes of code blocks h-1 and h.  Each column is encoded in a similar manner so that the code bytes for that column are positioned in code blocks h-1 and h, the column position of each corresponding to the column of encoded data bytes.  Again, the last two bytes of each code block may be used for encoding either the associated vertical or horizontal block, the latter being preferable.

Decoding Data Block Bundles:

To decode bundles of data blocks, encoded according to the above, comprising encoded vertical and horizontal data blocks, bit error patterns for one or two incorrect data bytes of each encoded data block are produced and used to correct the incorrect bytes.  Decoding of vertical and horizontal data blocks is performed according to the above description under the heading "Decoding According to Code C.".

All data blocks of the bundle (i.e. horizontal data blocks), are decoded as they are received, according to the above, to detect and correct all one or two byte errors which are correctable by Code C. Then, each vertical data block is identified and decoded in like manner until all vertical data blocks have been decoded. That is, until all correctable one or two byte errors occurring in each vertical data block have been corrected. The reader will recognize that horizontal data byte corrections themselves may enable further byte corrections upon decoding vertical data blocks. To illustrate this, suppose that, in Figure 1, bytes $B_0$ and $B_1$ of data block 1, bytes $B_0$, $B_1$ and $B_2$ of data block 2, and bytes $B_0$, $B_1$ and $B_4$ of data block 3 are received in error. The incorrect bytes $B_0$ and $B_1$ of data block 1, are corrected upon decoding data block 1 (assuming that the bytes show parity failure). However, the incorrect bytes of the second and third data blocks cannot, as yet, be corrected because more than two incorrect bytes have occurred in those data blocks. Following the decoding of (horizontal) data blocks the first vertical data block contains only two incorrect bytes because of the correction made upon decoding horizontal data block 1. Thus the incorrect bytes of the first vertical data block can now be corrected upon decoding the block (again assuming that the incorrect bytes show parity failure). Thus, the correction of byte $B_0$ of horizontal data block 1, performed upon decoding horizontal data block 1, enables byte corrections to be made upon decoding vertical data block 1. This is because horizontal decoding may reduce the number of incorrect bytes occurring in vertical data blocks. Similarly, if vertical data block decoding results in some byte corrections, those corrections may enable further corrections to be made upon a second cycle of horizontal data block decoding. To illustrate this, consider the above example again. Decoding vertical data block 1 results in the correction of bytes $B_0$ of horizontal data blocks 2 and 3. Thereafter, horizontal data blocks 2 and 3 each contain only two bytes in error and each of those two incorrect bytes can be corrected by decoding (horizontal) data blocks 2 and 3 once again.

This process of horizontal and vertical decoding, can be repeated as often as desired, to correct a number of incorrect bytes remaining in the bundle. If a byte correction is not made during the current decoding cycle, (i.e. horizontal or vertical decoding), there is no point in going through another decoding cycle because no more errors will be correctable than were in the last such cycle. The optimal number of decoding cycles selected depends upon the probable error pattern of the bundle data bytes which in turn is dependent upon a number of factors such as the selection of transmission channel, modulation method, etc. Accordingly, it may be desirable to adapt the apparatus and method described herein to perform repetitive horizontal and vertical decoding cycles satisfactorily within selected operating parameters.

By way of example, apparatuses for encoding and decoding data blocks and bundles of data blocks, according to the above, will now be described. However, the examples provided are for the purpose illustration only and the scope of the present invention is not limited to the disclosed embodiments of the invention. As is well-known in the electronic communications industry, most logic (including arithmetic logic) designs which perform a particular task can be implemented in a variety of ways; for example, by using a microprocessor-based circuit design controlled by a selectable set of instructions recorded in Read Only Memory (ROM). Due to the relative simplicity of a microprocessor design and the smaller number of discrete circuit devices required for the same, as compared with functionally equivalent discrete logic device designs, it is normally preferable to implement complex logic designs using a microprocessor. However, if for some reason it is desired to implement the present invention using a functionally equivalent combination of discrete logic devices, or medium-scale or large-scale integration devices, it is a relatively simple procedure to do so, for one skilled in the art, given the present disclosure of the invention and, in particular, the following descriptions of apparatuses.

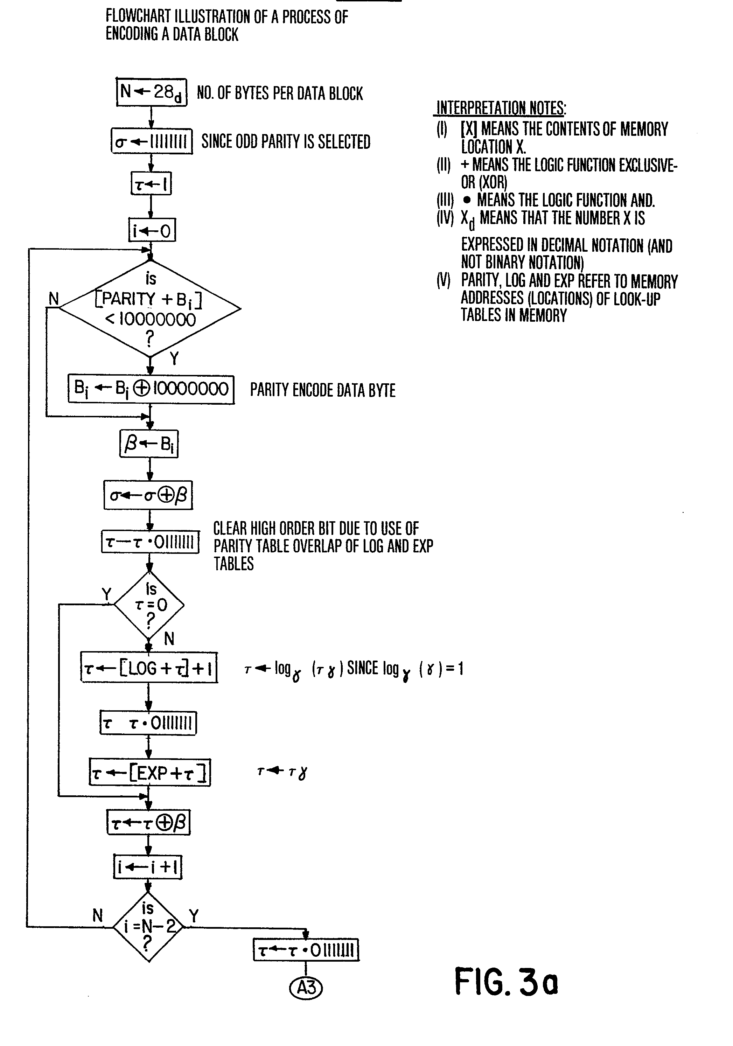

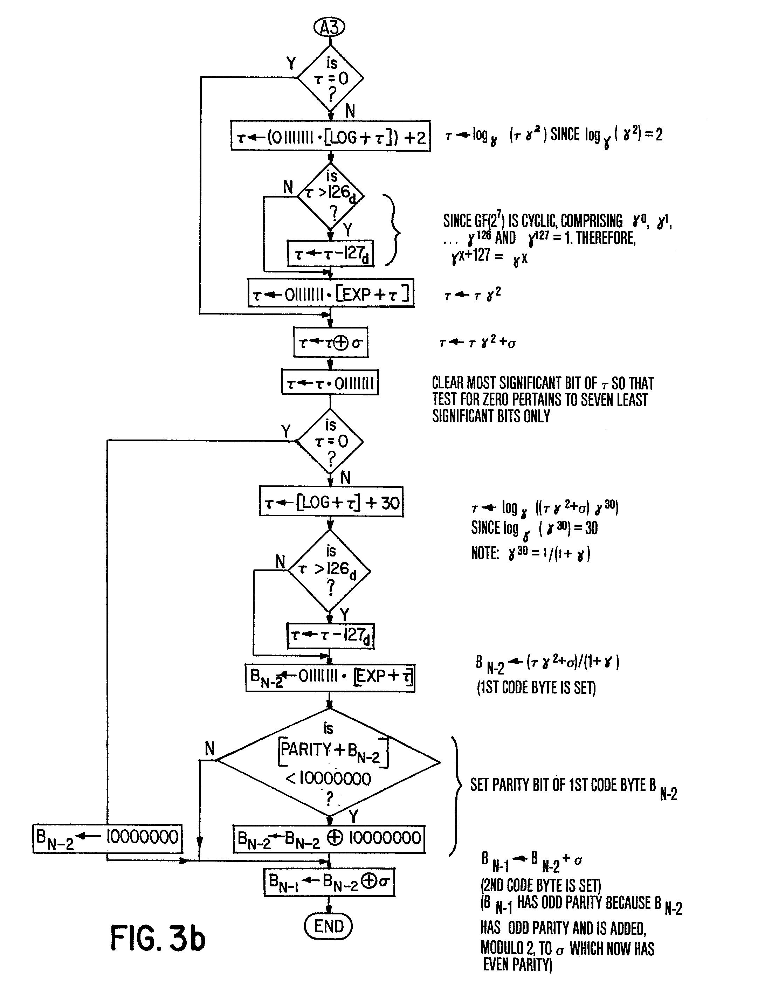

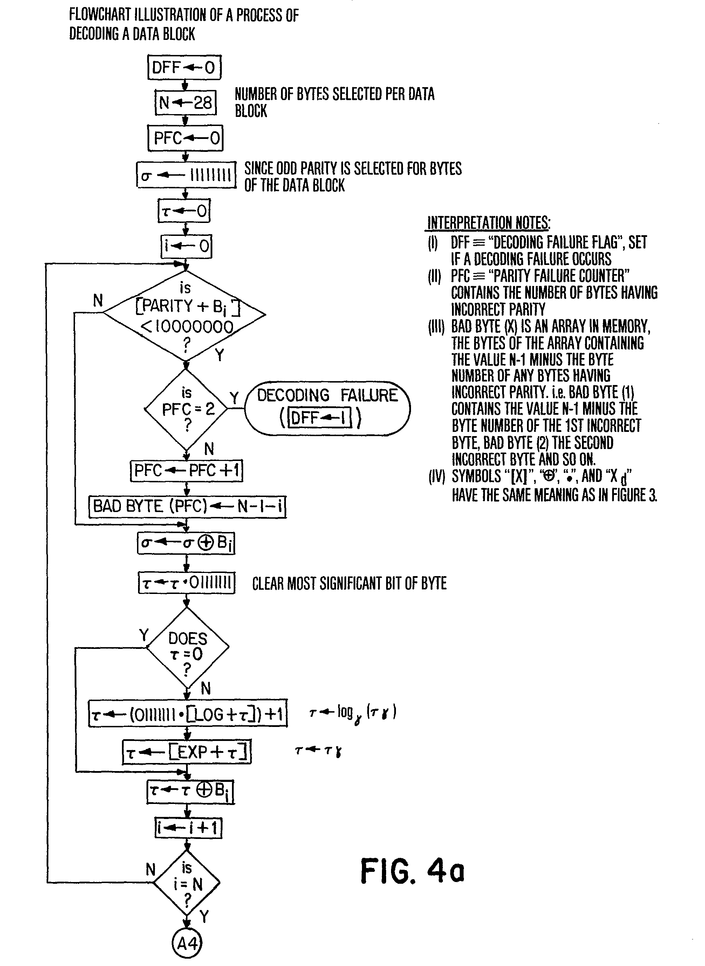

In the present system, a microprocessor-based means to encode and decode a data block and a bundle of data blocks, is selected. Numerous specific circuit designs might be appropriate for any particular application of the present invention, depending upon desired speed, cost, etc. A specific circuit design is not described herein; one skilled in the art can readily design appropriate circuitry, as desired, to implement the present invention given the following description and the flowcharts of Figures 3 to 8. As will be noted by the reader, these flowcharts include many descriptive notes concerning the steps of the processes illustrated by the flowcharts. A detailed description of the flowcharts is not repeated in the following text; reference should be made to Figures 3 to 8 for explanatory comments, the figures being substantially self-explanatory.

Apparatus to Encode a Data Block:

As indicated above, a microprocessor-based circuit design has been selected to encode a data block, according to the above description of encoding data blocks using Code C. The data bits of data bytes are encoded and, therefore, the Galois field $GF(2^7)$ is selected for use as described above. In general terms, the following description is equally applicable to the case where all bits (i.e. data and parity bits) are encoded and the Galois field $GF(2^8)$ is selected. Some modification of the following description is necessary for the latter case; however, the modifications necessary can be readily effected by someone having even a minimum level of skill in the art of writing instruction programs to implement a particular task or process.

Figure 3 shows, in flow chart form, the steps (i.e. operations) performed by the microprocessor in the preferred embodiment of the invention to encode a data block. As described above, the data bytes $B_0$ to $B_{25}$ are encoded according to the relationship (8) and (9) above. Look-up tables are used to set the parity check bits, of the data bytes, and to accomplish multiplication because this method of doing so requires less time (i.e. fewer microprocessor cycles) and is simple to do when a microprocessor design is selected. The disadvantage of the method is that additional memory is required to hold the information of the look-up tables. The effect of this is reduced by overlapping the look-up tables. Specifically, the parity check-bit table (PARITY) overlaps the logarithm (LOG) and exponential (EXP) tables. This is possible because only the most significant bits of the bytes of the parity table are required and the seven least significant bits of the bytes of the logarithm and exponential tables. Furthermore, the parity table contains $2^8$ (i.e. 256) elements and the logarithm and exponential tables each contain $2^7$ (i.e. 127) elements and, therefore, the parity table exactly fits over the exponential and logarithm tables. Thus, only 256 memory bytes are required to store all three tables.

The tables are arranged in memory so that the position offset, from the top of the table to a particular element in the table, corresponds to the information contained in that memory element. To illustrate this, consider one element of each table, for example, the tenth element of the tables PARITY, LOG and EXP.

If, for example, table PARITY starts at memory location 1024, then the most significant bit of memory location 1024 + 10 (i.e. memory location 1034) is set according to the parity of the offset byte, so that the parity of the offset byte can be determined immediately by checking the bit of memory location PARITY + 10. (This saves having to add together each bit of the offset byte to determine the parity of the byte entailing several steps and, therefore, consuming a significant amount of processing time.) The byte $B_i$ equal to 00001010, having the decimal value 10, when added to the value PARITY (PARITY being the value 1024 equal to the address of the first memory location of the table PARITY), addresses the tenth element of the PARITY table and that element contains a 1 in the most significant bit. The bit is a 1 because the offset byte of the address of the table element, i.e. 00001010, has even parity. However, it is desired that it have odd parity, so the bit is set to 1 to indicate that the parity of the offset byte is incorrect and must be set as desired. Therefore, by adding the byte $B_i$, whose parity is to be determined, to the value PARITY, and checking the most significant bit of the memory location PARITY + $B_i$, the parity of the offset ("look-up") byte $B_i$, is determined.

The form of tables LOG and EXP is similar to the form of table PARITY, but in each case it is the 7 least significant bits of the table elements which are of interest and not the most significant bit. Table LOG is given the same starting location as table PARITY and table EXP starts immediately at the end of table LOG (i.e. corresponding to the location of the 129th element of table PARITY). The 10th element of table LOG, is addressed by the value of the first 7 bits (i.e. the data bits) of the byte $B_i$ plus the value LOG (i.e. 1024). This element contains, in the first 7 bits, the value log (0001010).

Therefore, by simply addressing the memory location the value of the logarithm of the data bits used to address the location is obtained.

It should be noted that it is necessary to clear the most significant bit of the byte $B_i$ before addressing the tables LOG and EXP because the offset value can be a value from 0 to 127 only if the Galois field $GF(2^7)$ is selected. This is because the offset value represents a Galois field element from 0 to 127. Similarly, when the tables LOG and EXP are addressed the most significant bit of the addressed memory locations should be cleared because, due to the overlap of the PARITY and LOG and EXP tables, the most significant bit of those locations is a parity check bit and does <u>not</u> form a part of the logarithm or exponential value. Under the Galois field $GF(2^7)$, $\log(x)$ and $e^x$ are 7 bits only (which enables one to use the 8th bit for parity checking i.e. the table PARITY.)

Table EXP is given the starting address 1024+128=1152. The contents of memory location $B_i$+EXP, being memory location 1052+10, contains the value $e^{10}$ in the seven least significant bits of the element. Therefore, by addressing memory location $B_i$+EXP, the value $e^{B_i}$ is obtained. (Note that here the value $B_i$ refers to the data bits of byte $B_i$ only.)

From Figure 3, it will be appreciated that multiplication (of 7 bit values) is performed by adding the logarithms of numbers together and then looking up the exponential value of the sum. To repeat, this method is selected to reduce the time required to determine the code bytes $B_{N-2}$ and $B_{N-1}$; it is not essential to the present invention.

The value $\Upsilon$ is determined according to relationship (5) above, using Horner's method of evaluating a polynomial. That is,

$$\Upsilon = B_0 \, \delta^{N-3} + B_1 \, \delta^{N-4} + \ldots + B_{N-3}$$

$$= (\ldots((B_0\delta + B_1)\delta + B_2)\delta \ldots)\delta + B_{N-3}$$

Apparatus to Decode a Data Block:

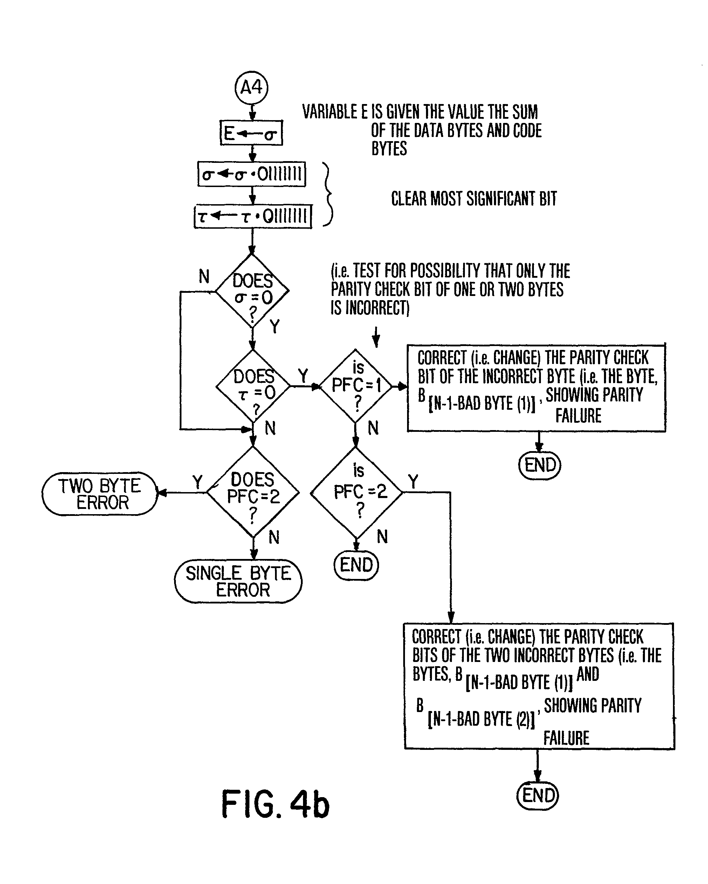

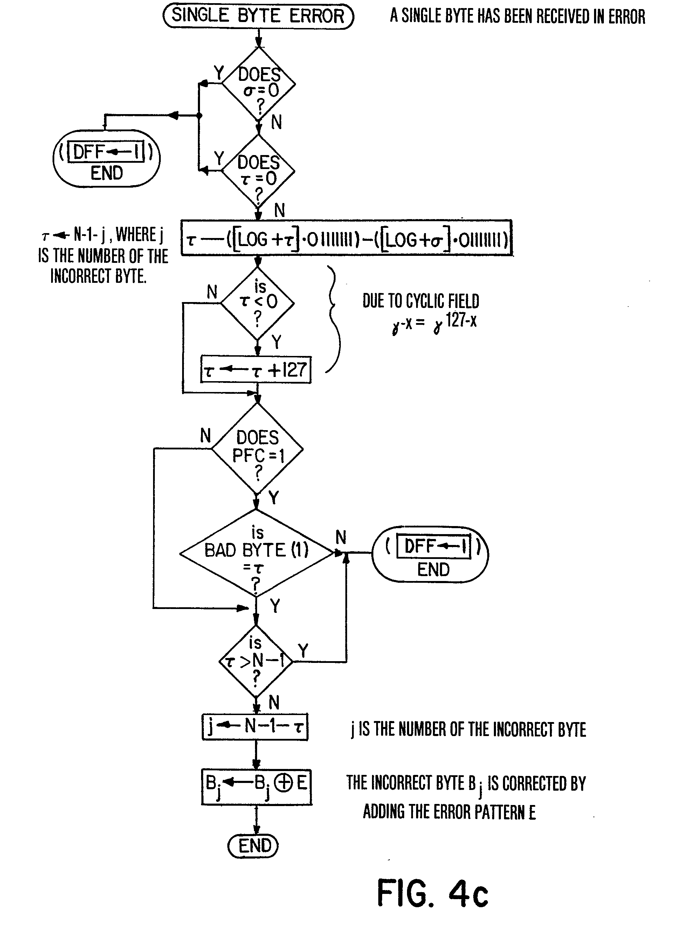

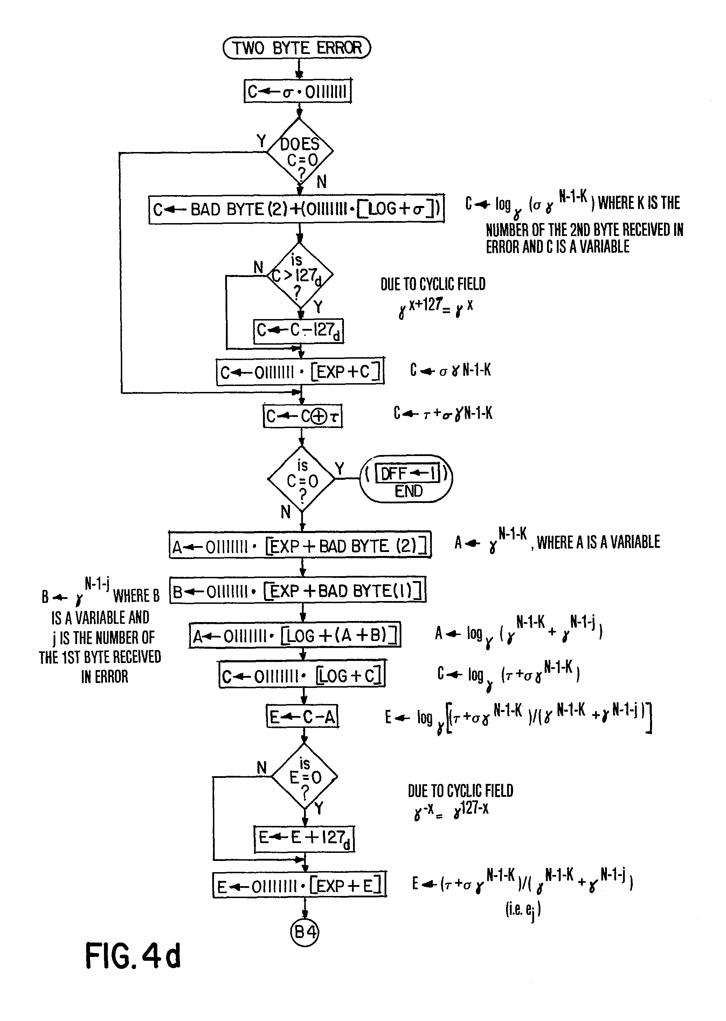

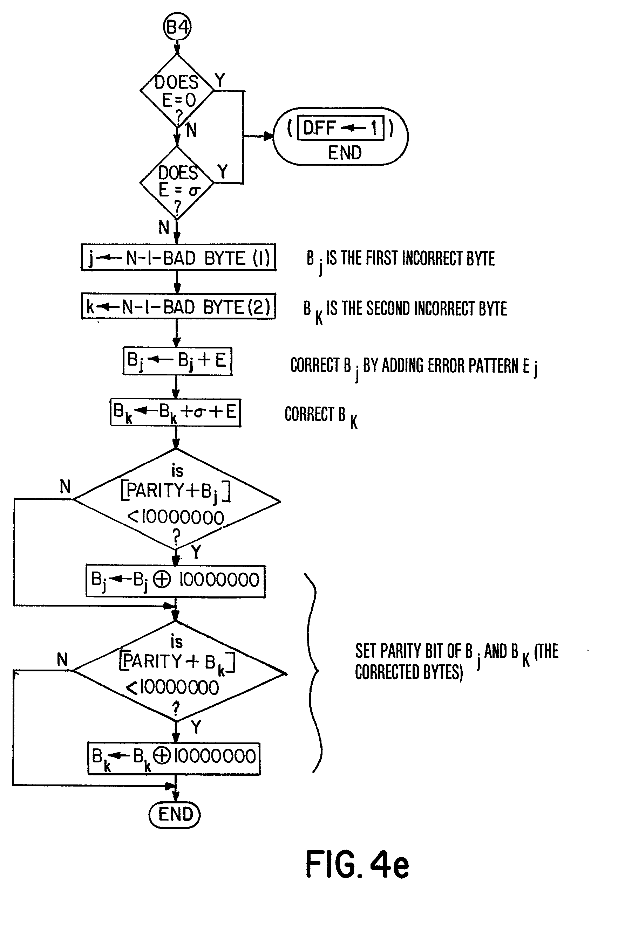

Figure 4 shows, in flow-chart form, the steps (i.e. operations) performed by the microprocessor in the preferred embodiment of the invention to decode a data block encoded according to the above. The look-up tables described above with respect to the encoder, are also used in the decoder. A description of the same is not repeated under this heading. The above comments pertaining to tables EXP and LOG are equally applicable with respect to the decoder.

The decoder tests each byte, $B_i$, of a data block for parity error and stores, in the one dimensional memory array BAD BYTE(X), the value N-1-i. This value is used to determine the value i of the incorrect byte $B_i$. For example, if bytes $B_4$ and $B_{10}$ have incorrect parity, then BAD BYTE(1) and BAD BYTE(2) will contain 23 (i.e. 28-1-4) and 17 (i.e. 28-1-10), respectively. The number of occurrences of detection of bytes having incorrect parity is counted by counter PFC.

Where one incorrect byte is received, (i.e. if PFC is 0 or 1), the steps of "SINGLE BYTE ERROR" are performed. The value j of the incorrect byte $B_j$, is determined by the difference of the logarithms of $\Upsilon$ and $\delta$ (i.e. which divides the two values) the result of which is N-1-j. The values $\delta$ and $\Upsilon$ are determined according to relationships (17) and (18) for $\delta'$ and $\Upsilon'$, respectively.

If two bytes having parity failure are detected the steps "TWO BYTE ERROR" are performed. The bit error patterns $e_j$ and $e_k$, defined by relationships (21) and (22) above, are determined by appropriate logarithms and exponentials used to multiply and divide bits as required. The values j and k of incorrect bytes $B_j$ and $B_k$, respectively, are the values stored in BAD BYTE(1) and BAD BYTE(2). The data bits of incorrect bytes $B_j$ and $B_k$ are corrected by adding to them the bit error patterns $e_j$ and $e_k$ (i.e. $e_k$ being equal to $\delta + e_j$), respectively. The corrected bytes $B_j$ and $B_k$ are parity encoded (the most significant bit being the parity check bit) using the look-up table PARITY.

This completes the discussion of encoding and decoding means for data blocks. The following describes the methods and apparatuses of the present invention to encode and decode bundles of data blocks.

Data Block Bundle Encoder:

As discussed above, there are two possible modes of bundle coding, namely, a first mode which uses 1 code block for vertical data block encoding and a second mode which uses 2 code blocks for vertical data block encoding. Of course, the advantage associated with the first mode is that a lesser amount of redundancy results and this enables a higher data transmission rate. However, if a greater degree of redundancy than that occurring from the first mode is acceptable, the second mode may be preferred because it provides better error correction capability. To illustrate this, consider the case of a burst of errors running over a sequence of two data blocks i.e. two rows of the bundle.

If the first mode is selected each vertical data block, comprising two columns of data bytes, contains 4 bytes in error (i.e. 2 bytes per horizontal data block and 2 bytes per column) which exceeds the correction capability of Code C. Therefore, the bytes in error cannot be corrected upon decoding the vertical data blocks of the bundle. Note that the first mode can correct one completely missing or erroneous data block (assuming that there are no errors occurring elsewhere in the bundle) since, in such case, each vertical data block contains only two bytes in error (i.e. one in each column of the vertical block).

In the case of two completely missing or erroneous data blocks, if the second mode of bundle coding has been selected the two data blocks can be corrected (i.e. replaced) upon vertical decoding. By the second mode of bundle coding each vertical data block comprises one column only of data bytes and each of the two code bytes are located in that column, each in a separate code block. Therefore, each vertical data block contains only two bytes in error (assuming that no errors occurred in that block other than the two bytes of the missing data blocks) and those bytes can be corrected (i.e. replaced) upon decoding the vertical block. Thus, the one-code-block bundle coding mode is capable of replacing one completely missing (horizontal) data block but is incapable of replacing two completely missing (horizontal) data blocks. However, the two-code-block bundle coding mode is capable of replacing one or two completely missing (horizontal) data blocks. Depending upon the application, one mode may be preferable over the other.

For the bundle encoder described herein the bundle format of the first mode of bundle coding conforms to Figure 1, described above. That is, each horizontal data block contains 28 bytes consisting of 26 data bytes (e.g. $B_0$ to $B_{25}$) and 2 code bytes (e.g. $B_{26}$ and $B_{27}$). Each vertical data block comprises two columns of the bundle array and contains $2(h-1)$ data bytes and 2 code bytes in code block h.

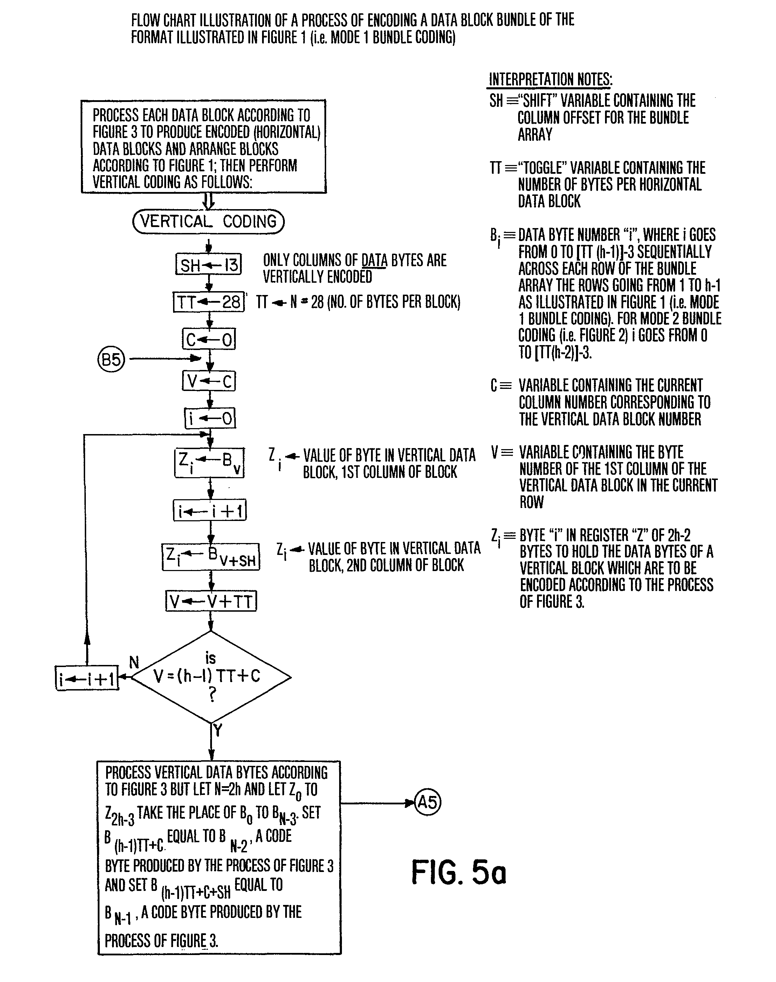

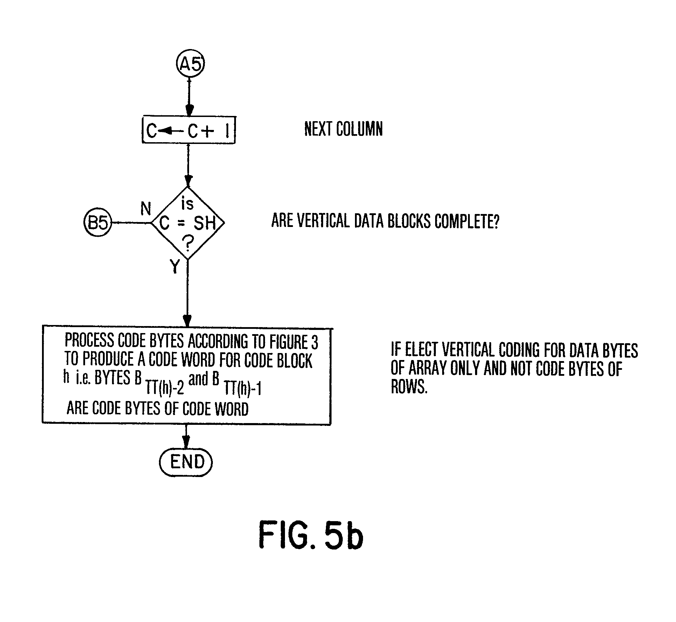

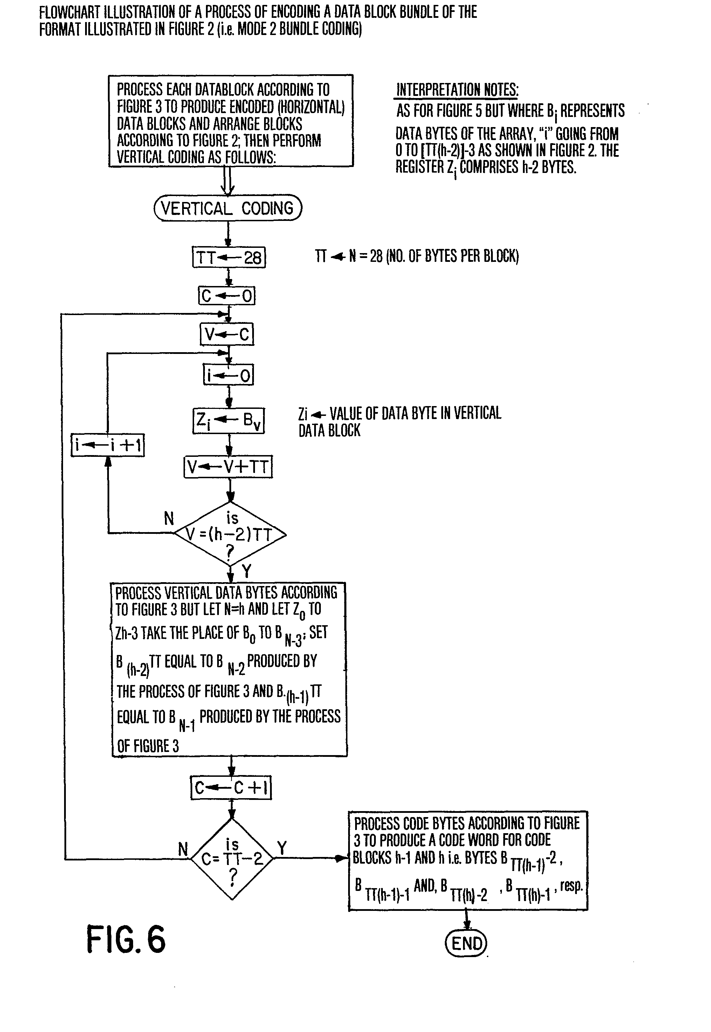

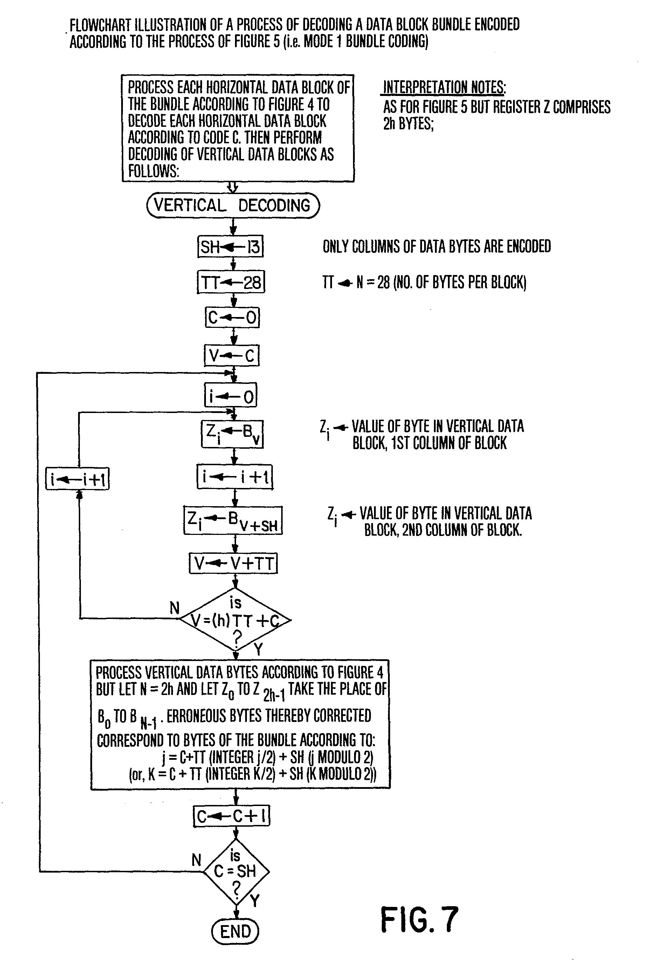

Figure 5 illustrates, by way of example, a process to encode a bundle of data blocks using one code block (i.e. mode 1). The variable C counts the columns of the bundle array and the variable SH holds the offset occurring between columns of a vertical data block. All data bytes in one vertical data block, $B_c$ to $B_{(h-1)TT+C+SH}$, are selected from the bundle array and processed according to Figure 3 discussed above. However, the number of data bytes so processed is not N-2 as for horizontal encoding, but instead is 2(h-1) (i.e. the number of data bytes comprising 2 columns of h-1 rows of data blocks). All pairs of columns, 0 and 13, 1 and 14, etc. to 12 and 25, are encoded with two code bytes according to Figure 3, the last byte of each pair of columns (i.e. in row h) being a code byte. The code bytes of row h are also encoded with two code bytes according to Figure 3, the 27th and 28th bytes of row h being the code bytes for the code block. If instead of encoding block h it is desired to vertically encode the code bytes of the horizontal data blocks, SH is let to equal 14 instead of 13 and the last step (i.e. before "end") is omitted from Figure 5.

If two code blocks are used for bundle encoding i.e. the second mode, the bundle format conforms to Figure 2 described above. That is, each horiziontal data block contains 28 bytes consisting of 26 data bytes (e.g. $B_0$ to $B_{25}$) and 2 code bytes (e.g. $B_{26}$ and $B_{27}$). Each vertical data block comprises one column of the bundle array and contains h-2 data bytes and 2 code bytes in code blocks h-1 and h.

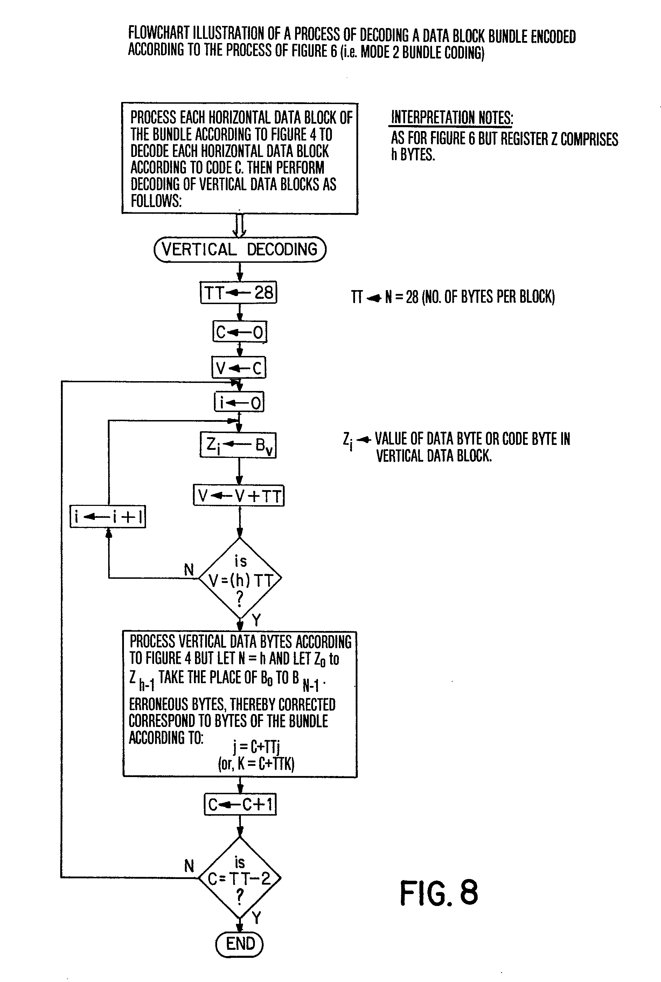

Figure 6 illustrates, by way of example, a process to encode a bundle of data blocks using two code blocks (i.e. mode 2). The process is the same as that shown in Figure 5 except that the offset of columns by SH bytes is not necessary since only one column of the array is included in each vertical data block. Also, if vertical coding of the code bytes for the horizontal data blocks is selected the variable C should be let to run to TT and the last step (i.e. before "end") should be deleted.

The above-described processes to encode a bundle of data blocks may be implemented using a variety of specific apparatus designs. In the preferred embodiment, the steps of the above described processes are performed by a microprocessor controlled by a specific set of instructions located in memory, the instructions conforming to the described processes. Of course, the particular selection of instructions is dependent upon the microprocessor selected. However, as a group, the selected instructions may operate equivalently to perform a particular task. The bundle decoder will now be described.

## Data Block Bundle Decoder:

The bundle decoder operates according to the processes illustrated, in flow-chart form, in Figure 7 or Figure 8. The processes of both Figure 7 and Figure 8 involve one decoding cycle only. That is, horizontal data block decoding is performed first and then vertical data block decoding is performed. As discussed above, it may be desirable to perform more than one bundle decoding cycle to increase the number of data bytes corrected upon decoding. If the last performed half cycle (i.e. vertical or horizontal decoding) resulted in the correction of one or more bytes, additional corrections may be possible upon further decoding cycles. Therefore, it may be desired that the decoder of the present invention include the step of counting the number of times horizontal decoding results in a byte (or 2 byte) correction. Likewise, for vertical decoding. Then, if the byte correction counter equals some selected value when the decoding cycle of Figure 7 or Figure 8 is complete, another decoding cycle, or half cycle, might be performed. Further decoding cycles or half cycles may be repeated as desired, according to the number of byte corrections occurring in the most recently completed half cycle.

Figure 7 illustrates, by way of example, a process to decode a bundle of data blocks encoded with one code block, the bundle conforming to the format illustrated in Figure 1. Each row (i.e. horizontal data blocks) of the bundle is decoded according to the above-described process of Figure 4 to decode a data block. Then, each vertical data block of the bundle is decoded according to the process of Figure 4. Variable C counts the columns of the vertical data blocks of the bundle and the variable SH is the byte offset between columns of a vertical data block. Since the process of Figure 4 is herein used to decode each vertical data block (as well as horizontal data blocks), the values of the incorrect bytes calculated by the process, being byte $B_j$ or bytes $B_j$ and $B_k$, are translated to the values of the associated bundle bytes and the bundle bytes are corrected.

For example, taking the first vertical data block, consisting of bytes $B_0$ and $B_{13}$ of row 1, $B_0$ and $B_{13}$ of row 2, etc., the bytes of the block are identified as bytes $B_0$ to $B_{N-1}$ for the processing of Figure 4 (N

denoting the number of bytes in the vertical data block viz. 2h bytes). The bit error patterns are determined for the bytes $B_j$ and $B_k$ being one of the bytes $B_0$ to $B_{N-1}$. To translate the values j and k to values corresponding to bundle bytes the vertical data block column number is added to the integer value of j/2 (i.e. the remainder of j/2 is ignored) multiplied by the number of bytes per horizontal data block (i.e. TT). Then, if j is an odd number the column offset SH is added (i.e. SH (j modulo 2)). By taking the integer value of j/2 multiplied by TT, the rows of the bundle are incremented once every two bytes. This is necessary because bytes $B_j$ and $B_{j+1}$ correspond to bytes of the same row, for example, $B_0$ and $B_{13}$.

Figure 8 illustrates, by way of example, a process for decoding a bundle of data blocks encoded with two code blocks (i.e. mode 2), the bundle conforming to the format of Figure 2. This process is the same as the process discussed above with respect to Figure 7, but in the case of mode 2 decoding, the step of shifting 13 columns once for every row is not necessary, since all bytes of a vertical data block are contained in one bundle array column. Therefore, the above-described translation from $B_j$ or $B_k$ to the corresponding bundle byte numbers is also unnecessary, and is excluded from the process of Figure 8.

The bundle decoder of the present invention described herein includes a microprocessor and controlling operating system in memory to perform the steps of Figures 7 and 8.

For the vertical block decoding of the first mode of bundle coding, the number N, identified in the process of Figure 4, is equal to 2h since each vertical block contains two columns of the bundle array, each column having h rows. For mode 2, N equals h since each vertical data block contains only one column of h rows.

As stated above, the bundle decoder apparatus of the present invention may be implemented by a process having a variety of discrete steps; however, a group of steps which performs equivalently the tasks of the process described herein may be considered the same process of the present invention. Likewise, the above-described processes for encoding and decoding data blocks and encoding data block bundles are not intended to limit the scope of the present invention. Depending upon the specific electronic devices selected to perform the described processes some departure from the description provided herein may be appropriate. For example, the architecture of one microprocessor may enable a particular task to be performed by one operating instruction set element, while another microprocessor may require several operating instruction set elements to perform the equivalent task. Thus, the particular set of operating instructions to control a given microprocessor, or other equivalently combined arrangement of circuit devices, are not included in the present invention, which is defined by the appended claims. Furthermore, and for the same reason, the specific steps of the processes described above are not included in the present invention. Rather, it is the combination of the functional groups of steps of the described processes which the present invention includes.

Given the above-described processes, any person normally skilled in the art can select a particular instruction set appropriate to the circuit devices (e.g. microprocessor, memory etc.) selected to perform the described process.

The invention and scope thereof is defined by the following claims.

PATENT CLAIMS

1.        A data block encoding device to encode a sequence of parity encoded data packets with two code packets, to permit the detection and correction of one incorrect packet occurring therein, or two incorrect packets if the two packets are identifiable, characterized in that it comprises:

(a)   identification means to identify packets of a sequence of data packets each packet containing one parity check bit;

(b)   processing means for producing two code packets such that the sum, using modulo 2 addition, of said data packets and said code packets is equal to zero and the sum of said data packets and said code packets, each packet multiplied by a particular unique Galois field element, is equal to zero, said processing means including:

 (i)   summing means to sum by modulo 2 addition two packets;

 (ii)  multiplication means to multiply two packets, each packet being representative of a Galois field element and said multiplication occurring within the Galois field comprising said elements over the Galois field of two elements, namely, 0 and 1;

 (iii) generating means to produce two code packets conforming to said two summations; and,

 (iv)  assembly means to assemble said code packets with said data packets to produce an encoded data block comprising data packets and two code packets, the two code packets comprising a codeword.

2. The device of claim 1, characterized in that said processing means includes a microprocessor and appropriate opperating system contained in memory to control said microprocessor and process said data packets.

3. A data block decoding device to decode a sequence of packets of a data block said data block comprising parity encoded data packets and two code packets to detect and correct one incorrect packet occurring therein or two incorrect packets if the two incorrect packets can each be identified, characterized in that it comprises:

(a) identification means to identify packets of said data block;

(b) processing means for producing one bit-error-pattern packet for one incorrect packet, or two bit-error-pattern packets for two incorrect packets, according to predetermined relationships between the packets of said data block, including:

    (i) parity check means to determine the parity of each of said data packets of said data block;

    (ii) byte-parity-error identifying means to permit identification of two packets of said data block having parity failure;

(iii)   summing means to sum by modulo 2 addition and multiplication means to determine, according to predetermined relationships between said packets, one bit-error-pattern packet for one incorrect packet and two bit-error-pattern packets for two identifiable incorrect packets, said multiplication occurring within a Galois field comprising elements capable of representation by said packets, over the Galois field of two elements namely, 0 and 1.

(c)   packet correction means to correct incorrect packets with said bit-error-pattern packets.

4.      The device of claim 2, characterized in that said processing means includes a microprocessor and appropriate operating system contained in memory to control said microprocessor and process said data and code packets.

5.      A data block bundle encoding device for encoding a number of data packets of a two dimensional array of data packets arranged so that the rows of the encoded bundle array comprise a number of horizontal data blocks each of said blocks encoded with two code packets, the bundle encoding device defined according to the device of claim 1, characterized in that it includes:

a)   means to identify encoded data blocks in array format said data blocks comprising  rows of said array; and,

(b)   selection means for selecting the packets of one or two
      columns of said array for encoding same with two code
      packets to produce one encoded vertical data block.


6.        A data block bundle decoding device to decode a
number of packets of a two dimensional array of packets said
array comprising rows of horizontal data blocks and columns of
vertical data blocks each said block encoded with two code
packets, said decoding device defined according to the device
of claim 3, characterized in that it includes:

(a)   identification means to identify said encoded horizontal
      and vertical data blocks of said bundle array;

(b)   selection means for selecting the packets comprising each
      of said horizontal and each of said vertical data blocks;

(c)   translation means for translating the value identifying
      said one or two bit-error-pattern packets to the
      corresponding value identifying the one or two incorrect
      packets of a horizontal data block or vertical data block
      of said bundle; and,

(d)   correction means to correct said one or two incorrect
      packets using said one or two bit-error-pattern packets.


7.        The device of claim 6, characterized in that it includes:

(a)   counting means to count packets of said horizontal or
      vertical data blocks which have been corrected using said
      bit-error-pattern packets; and,

(b)    trigger means to direct said device to again decode said
       horizontal data blocks or vertical data blocks to correct
       one or two incorrect packets occurring therein.


8.        A method of encoding a sequence of parity encoded
data packets with two code packets, to permit the detection and
correction of one incorrect packet occurring therein, or two
incorrect packets if the two packets are identifiable, characterized
by the following steps:

(a)    identifying packets of a sequence of data packets, each
       packet containing one parity check bit; and,

(b)    producing two code packets such that the sum, using
       modulo 2 addition, of said data packets and said code
       packets is equal to zero and the sum of said data packets
       and said code packets, each packet having been multiplied
       by a particular Galois field element over the Galois field
       of two elements 0 and 1, is equal to zero.


9.        A method of decoding a sequence of packets of a data
block said data block comprising parity encoded data packets
and two code packets to detect and correct one incorrect packet
occurring therein or two incorrect packets if the two incorrect
packets can each be identified, characterized by the following steps:

(a)    identifying packets of said data block;

(b)    producing one bit-error-pattern packet for one incorrect
       packet, or two bit-error-pattern packets for two incorrect packets, according to predetermined relationships of the packets of said data block, including the steps:

   (i)   determining the parity of said data packets of said data block;

   (ii)   identifying the two packets of said data block having parity failure if two packets are determined to have incorrect parity;

  (iii)   producing according to predetermined relationships of said packets one bit-error-pattern packet for one incorrect packet or two bit-error-pattern packets for two identifiable incorrect packets;

(c)   correcting the said one or two incorrect packets with said one or two bit-error-pattern packets.


10.      A method of encoding a bundle of data blocks comprising a number of data packets of a two dimensional array of data packets the packets arranged so that each row of the array comprises a horizontal data block each block encoded with two code packets, the method comprising the steps of claim 8, characterized in that it includes the steps of selecting the packets of one or two columns of said array forming a block of data packets and encoding said selected packets with two code packets according to the method of claim 8 to produce an encoded vertical data block.


11.      A method of decoding an encoded data block bundle comprising a number of data packets of a two dimensional array of packets said array comprising rows of horizontal data blocks and columns of vertical data blocks each said block encoded with two code packets, characterized in that said method comprises the step of decoding said horizontal and vertical data blocks according to claim 9, the packets of said blocks having been selected before said blocks are decoded.

12.       The method of claim 11, characterized in that it includes the steps:

(a)   counting packets of said horizontal or vertical data blocks which have been corrected; and,

(b)   repeating the steps for decoding said horizontal data blocks or vertical data blocks to correct one or two incorrect packets occurring therein if the number of packets corrected exceeds a selected value.

0 164 027

1/13

BUNDLE CODING BYTE ARRANGEMENT
COMPRISING ONE CODE BLOCK (i.e. MODE 1
BUNDLE CODING)

BYTE $B_{12}$ OF DATA BLOCK 1 OR, BYTE $B_{12}$ OF
THE BUNDLE

BYTE $B_{14}$ OF DATA BLOCK 2 OR, BYTE $B_{42}$ OF
THE BUNDLE

HORIZONTAL DATA
BLOCK 1

DATA BLOCKS

CODEWORDS FOR
VERTICAL DATA
BLOCKS

VERTICAL DATE BLOCK 1 WITH TWO CODE
BYTES $B_0$ AND $B_{13}$ OF CODE BLOCK h

VERTICAL DATA BLOCK 2 WITH TWO CODE
BYTES $B_1$, AND $B_{14}$ OF CODE BLOCK h

CODEWORDS FOR HORIZONTAL
DATA BLOCKS

VERTICAL DATA BLOCK 13 WITH TWO CODE
BYTES $B_{12}$ AND $B_{25}$ OF CODE BLOCK h

FIG. 1

BUNDLE CODING BYTE ARRANGEMENT
COMPRISING TWO CODE BLOCKS (i.e. MODE 2
BUNDLE CODING)

BYTE $B_{12}$ OF DATA BLOCK 1 OR, BYTE $B_{12}$ OF
THE BUNDLE

BYTE $B_{14}$ OF DATA BLOCK 2 OR,
BYTE $B_{42}$ OF THE BUNDLE

HORIZONTAL DATA
BLOCK 1

DATA BLOCKS

CODE WORDS FOR
VERTICAL DATA
BLOCKS

VERTICAL DATA BLOCK 1 WITH TWO CODE
BYTES, $B_0$ OF BLOCKS h-1 AND h

VERTICAL DATA BLOCK 14 WITH TWO CODE
BYTES, $B_0$ OF BLOCKS h-1 AND h

CODEWORDS FOR HORIZONTAL
DATA BLOCKS

FIG. 2

FLOWCHART ILLUSTRATION OF A PROCESS OF
ENCODING A DATA BLOCK

$N \leftarrow 28_d$  NO. OF BYTES PER DATA BLOCK

$\sigma \leftarrow 11111111$  SINCE ODD PARITY IS SELECTED

$\tau \leftarrow 1$

$i \leftarrow 0$

is
$[PARITY + B_i]$
< 10000000
?

$B_i \leftarrow B_i \oplus 10000000$  PARITY ENCODE DATA BYTE

$\beta \leftarrow B_i$

$\sigma \leftarrow \sigma \oplus \beta$

$\tau \leftarrow \tau \cdot 01111111$  CLEAR HIGH ORDER BIT DUE TO USE OF
PARITY TABLE OVERLAP OF LOG AND EXP
TABLES

Is
$\tau = 0$
?

$\tau \leftarrow [LOG + \tau] + 1$  $\tau \leftarrow \log_\gamma (\tau \gamma)$ SINCE $\log_\gamma (\gamma) = 1$

$\tau \quad \tau \cdot 01111111$

$\tau \leftarrow [EXP + \tau]$  $\tau \leftarrow \tau \gamma$

$\tau \leftarrow \tau \oplus \beta$

$i \leftarrow i + 1$

is
$i = N - 2$
?

$\tau \leftarrow \tau \cdot 01111111$

A3

INTERPRETATION NOTES:
(I)  [X] MEANS THE CONTENTS OF MEMORY
LOCATION X.
(II)  + MEANS THE LOGIC FUNCTION EXCLUSIVE-
OR (XOR)
(III)  • MEANS THE LOGIC FUNCTION AND.
(IV)  $X_d$ MEANS THAT THE NUMBER X IS
EXPRESSED IN DECIMAL NOTATION (AND
NOT BINARY NOTATION)
(V)  PARITY, LOG AND EXP REFER TO MEMORY
ADDRESSES (LOCATIONS) OF LOOK-UP
TABLES IN MEMORY

FIG. 3a

3/13

(A3)

is $\tau = 0$ ? — Y / N

$\tau \leftarrow (01111111 \cdot [LOG + \tau]) + 2$    $\tau \leftarrow \log_\gamma (\tau \gamma^2)$ SINCE $\log_\gamma (\gamma^2) = 2$

is $\tau > 126_d$ ? — N / Y

$\tau \leftarrow \tau - 127_d$

SINCE $GF(2^7)$ IS CYCLIC, COMPRISING $\gamma^0$, $\gamma^1$, ... $\gamma^{126}$ AND $\gamma^{127} = 1$. THEREFORE, $\gamma^{x+127} = \gamma^x$

$\tau \leftarrow 01111111 \cdot [EXP + \tau]$    $\tau \leftarrow \tau \gamma^2$

$\tau \leftarrow \tau \oplus \sigma$    $\tau \leftarrow \tau \gamma^2 + \sigma$

$\tau \leftarrow \tau \cdot 01111111$    CLEAR MOST SIGNIFICANT BIT OF $\tau$ SO THAT TEST FOR ZERO PERTAINS TO SEVEN LEAST SIGNIFICANT BITS ONLY

is $\tau = 0$ ? — Y / N

$\tau \leftarrow [LOG + \tau] + 30$    $\tau \leftarrow \log_\gamma ((\tau \gamma^2 + \sigma) \gamma^{30})$ SINCE $\log_\gamma (\gamma^{30}) = 30$ NOTE: $\gamma^{30} = 1/(1 + \gamma)$

is $\tau > 126_d$ ? — N / Y

$\tau \leftarrow \tau - 127_d$

$B_{N-2} \leftarrow 01111111 \cdot [EXP + \tau]$    $B_{N-2} \leftarrow (\tau \gamma^2 + \sigma)/(1 + \gamma)$ (1ST CODE BYTE IS SET)

is $[PARITY + B_{N-2}] < 10000000$ ? — N / Y

$B_{N-2} \leftarrow 10000000$

$B_{N-2} \leftarrow B_{N-2} \oplus 10000000$

SET PARITY BIT OF 1ST CODE BYTE $B_{N-2}$

$B_{N-1} \leftarrow B_{N-2} \oplus \sigma$

$B_{N-1} \leftarrow B_{N-2} + \sigma$ (2ND CODE BYTE IS SET) ($B_{N-1}$ HAS ODD PARITY BECAUSE $B_{N-2}$ HAS ODD PARITY AND IS ADDED, MODULO 2, TO $\sigma$ WHICH NOW HAS EVEN PARITY)

(END)

FIG. 3b

FLOWCHART ILLUSTRATION OF A PROCESS OF
DECODING A DATA BLOCK

$$DFF \leftarrow 0$$

$$N \leftarrow 28$$ NUMBER OF BYTES SELECTED PER DATA BLOCK

$$PFC \leftarrow 0$$

$$\sigma \leftarrow 11111111$$ SINCE ODD PARITY IS SELECTED FOR BYTES OF THE DATA BLOCK

$$\tau \leftarrow 0$$

$$i \leftarrow 0$$

is $$[PARITY + B_i] < 10000000 ?$$ — N

is PFC = 2 ? — Y → DECODING FAILURE ($$\boxed{DFF \leftarrow 1}$$)

N

$$PFC \leftarrow PFC + 1$$

$$BAD\ BYTE\ (PFC) \leftarrow N-1-i$$

$$\sigma \leftarrow \sigma \oplus B_i$$

$$\tau \leftarrow \tau \cdot 01111111$$ CLEAR MOST SIGNIFICANT BIT OF BYTE

DOES $$\tau = 0 ?$$ — Y

N

$$\tau \leftarrow (01111111 \cdot [LOG + \tau]) + 1$$    $$\tau \leftarrow \log_\gamma (\tau \gamma)$$

$$\tau \leftarrow [EXP + \tau]$$    $$\tau \leftarrow \tau \gamma$$

$$\tau \leftarrow \tau \oplus B_i$$

$$i \leftarrow i + 1$$

is i = N ? — N / Y

(A4)

**FIG. 4a**

INTERPRETATION NOTES:

(I) DFF ≡ "DECODING FAILURE FLAG", SET IF A DECODING FAILURE OCCURS

(II) PFC ≡ "PARITY FAILURE COUNTER" CONTAINS THE NUMBER OF BYTES HAVING INCORRECT PARITY

(III) BAD BYTE (X) IS AN ARRAY IN MEMORY, THE BYTES OF THE ARRAY CONTAINING THE VALUE N-1 MINUS THE BYTE NUMBER OF ANY BYTES HAVING INCORRECT PARITY. i.e. BAD BYTE (1) CONTAINS THE VALUE N-1 MINUS THE BYTE NUMBER OF THE 1ST INCORRECT BYTE, BAD BYTE (2) THE SECOND INCORRECT BYTE AND SO ON.

(IV) SYMBOLS "[X]", "⊕", "•", AND "X $_d$" HAVE THE SAME MEANING AS IN FIGURE 3.

(A4)

$E \leftarrow \sigma$

VARIABLE E IS GIVEN THE VALUE THE SUM
OF THE DATA BYTES AND CODE
BYTES

$\sigma \leftarrow \sigma \cdot 0111111$

$\tau \leftarrow \tau \cdot 0111111$

CLEAR MOST SIGNIFICANT BIT

DOES
$\sigma = 0$
?

(i.e. TEST FOR POSSIBILITY THAT ONLY THE
PARITY CHECK BIT OF ONE OR TWO BYTES
IS INCORRECT)

N

DOES
$\tau = 0$
?

Y

is
PFC = 1
?

Y

CORRECT (i.e. CHANGE) THE PARITY CHECK
BIT OF THE INCORRECT BYTE (i.e. THE BYTE,
$B_{[N-1-BAD\ BYTE\ (1)]}$, SHOWING PARITY
FAILURE

N

N

END

TWO BYTE
ERROR

Y

DOES
PFC = 2
?

N

is
PFC = 2
?

Y

N

END

SINGLE BYTE
ERROR

CORRECT (i.e. CHANGE) THE PARITY CHECK
BITS OF THE TWO INCORRECT BYTES (i.e. THE
BYTES, $B_{[N-1-BAD\ BYTE\ (1)]}$ AND
$B_{[N-1-BAD\ BYTE\ (2)]}$, SHOWING PARITY
FAILURE

END

FIG. 4b

.6/13

SINGLE BYTE ERROR        A SINGLE BYTE HAS BEEN RECEIVED IN ERROR

DOES $\sigma = 0$ ? — Y

$(\boxed{DFF \leftarrow 1})$ END

DOES $\tau = 0$ ? — Y

$\tau \leftarrow N-1-j$, WHERE j IS THE NUMBER OF THE INCORRECT BYTE.

$\tau \longleftarrow (\boxed{LOG + \tau} \cdot 0\,1111111) - (\boxed{LOG + \sigma} \cdot 01111111)$

is $\tau < 0$ ? — N

DUE TO CYCLIC FIELD $\gamma^{-x} = \gamma^{127-x}$

$\tau \leftarrow \tau + 127$

DOES PFC = 1 ? — N

is BAD BYTE (1) $= \tau$ ? — N

$(\boxed{DFF \leftarrow 1})$ END

is $\tau > N-1$ ? — Y

$j \leftarrow N-1-\tau$        j IS THE NUMBER OF THE INCORRECT BYTE

$B_j \leftarrow B_j \oplus E$        THE INCORRECT BYTE $B_j$ IS CORRECTED BY ADDING THE ERROR PATTERN E

END

FIG. 4c

TWO BYTE ERROR

$C \leftarrow \sigma \cdot 0IIIIIII$

DOES C=0 ? — Y / N

$C \leftarrow$ BAD BYTE (2) + (0IIIIIII · [LOG + $\sigma$])

$C \leftarrow \log_{\gamma} (\sigma \gamma^{N-1-K})$ WHERE K IS THE NUMBER OF THE 2ND BYTE RECEIVED IN ERROR AND C IS A VARIABLE

is C > 127$_d$ ? — N / Y

DUE TO CYCLIC FIELD
$\gamma^{x+127} = \gamma^{x}$

$C \leftarrow C - 127_d$

$C \leftarrow 0IIIIIII \cdot [EXP + C]$

$C \leftarrow \sigma \gamma^{N-1-K}$

$C \leftarrow C \oplus \tau$

$C \leftarrow \tau + \sigma \gamma^{N-1-K}$

is C=0 ? — Y → ([DFF ← 1]) END

N

$A \leftarrow 0IIIIIII \cdot [EXP + BAD BYTE (2)]$

$A \leftarrow \gamma^{N-1-K}$, WHERE A IS A VARIABLE

$B \leftarrow 0IIIIIII \cdot [EXP + BAD BYTE(1)]$

$B \leftarrow \gamma^{N-1-j}$ WHERE B IS A VARIABLE AND j IS THE NUMBER OF THE 1ST BYTE RECEIVED IN ERROR

$A \leftarrow 0IIIIIII \cdot [LOG + (A + B)]$

$A \leftarrow \log_{\gamma} (\gamma^{N-1-K} + \gamma^{N-1-j})$

$C \leftarrow 0IIIIIII \cdot [LOG + C]$

$C \leftarrow \log_{\gamma} (\tau + \sigma \gamma^{N-1-K})$

$E \leftarrow C - A$

$E \leftarrow \log_{\gamma} [(\tau + \sigma \gamma^{N-1-K}) / (\gamma^{N-1-K} + \gamma^{N-1-j})]$

is E=0 ? — N / Y

DUE TO CYCLIC FIELD
$\gamma^{-x} = \gamma^{127-x}$

$E \leftarrow E + 127_d$

$E \leftarrow 0IIIIIII \cdot [EXP + E]$

$E \leftarrow (\tau + \sigma \gamma^{N-1-K}) / (\gamma^{N-1-K} + \gamma^{N-1-j})$
(i.e. $e_j$)

B4

FIG. 4d

FIG. 4e

FLOW CHART ILLUSTRATION OF A PROCESS OF ENCODING A DATA BLOCK BUNDLE OF THE
FORMAT ILLUSTRATED IN FIGURE 1 (i.e. MODE 1 BUNDLE CODING)

INTERPRETATION NOTES:

$SH \equiv$ "SHIFT" VARIABLE CONTAINING THE COLUMN OFFSET FOR THE BUNDLE ARRAY

$TT \equiv$ "TOGGLE" VARIABLE CONTAINING THE NUMBER OF BYTES PER HORIZONTAL DATA BLOCK

$B_i \equiv$ DATA BYTE NUMBER "i", WHERE i GOES FROM 0 TO $[TT(h-1)]-3$ SEQUENTIALLY ACROSS EACH ROW OF THE BUNDLE ARRAY THE ROWS GOING FROM 1 TO h-1 AS ILLUSTRATED IN FIGURE 1 (i.e. MODE 1 BUNDLE CODING). FOR MODE 2 BUNDLE CODING (i.e. FIGURE 2) i GOES FROM 0 TO $[TT(h-2)]-3$.

$C \equiv$ VARIABLE CONTAINING THE CURRENT COLUMN NUMBER CORRESPONDING TO THE VERTICAL DATA BLOCK NUMBER

$V \equiv$ VARIABLE CONTAINING THE BYTE NUMBER OF THE 1ST COLUMN OF THE VERTICAL DATA BLOCK IN THE CURRENT ROW

$Z_i \equiv$ BYTE "i" IN REGISTER "Z" OF 2h-2 BYTES TO HOLD THE DATA BYTES OF A VERTICAL BLOCK WHICH ARE TO BE ENCODED ACCORDING TO THE PROCESS OF FIGURE 3.

PROCESS EACH DATA BLOCK ACCORDING TO FIGURE 3 TO PRODUCE ENCODED (HORIZONTAL) DATA BLOCKS AND ARRANGE BLOCKS ACCORDING TO FIGURE 1; THEN PERFORM VERTICAL CODING AS FOLLOWS:

VERTICAL CODING

$SH \leftarrow 13$ — ONLY COLUMNS OF DATA BYTES ARE VERTICALLY ENCODED

$TT \leftarrow 28$ — $TT \leftarrow N = 28$ (NO. OF BYTES PER BLOCK)

$C \leftarrow 0$

(B5)

$V \leftarrow C$

$i \leftarrow 0$

$Z_i \leftarrow B_V$ — $Z_i \leftarrow$ VALUE OF BYTE IN VERTICAL DATA BLOCK, 1ST COLUMN OF BLOCK

$i \leftarrow i + 1$

$Z_i \leftarrow B_{V+SH}$ — $Z_i \leftarrow$ VALUE OF BYTE IN VERTICAL DATA BLOCK, 2ND COLUMN OF BLOCK

$V \leftarrow V + TT$

$i \leftarrow i + 1$ ← N — is $V = (h-1)TT + C$ ? — Y

PROCESS VERTICAL DATA BYTES ACCORDING TO FIGURE 3 BUT LET N=2h AND LET $Z_0$ TO $Z_{2h-3}$ TAKE THE PLACE OF $B_0$ TO $B_{N-3}$. SET $B_{(h-1)TT+C}$ EQUAL TO $B_{N-2}$, A CODE BYTE PRODUCED BY THE PROCESS OF FIGURE 3 AND SET $B_{(h-1)TT+C+SH}$ EQUAL TO $B_{N-1}$, A CODE BYTE PRODUCED BY THE PROCESS OF FIGURE 3.

(A5)

FIG. 5a

(A5)

$C \leftarrow C + 1$    NEXT COLUMN

N    is
(B5)—$C = SH$    ARE VERTICAL DATA BLOCKS COMPLETE?
    ?
    Y

PROCESS CODE BYTES ACCORDING TO FIGURE 3
TO PRODUCE A CODE WORD FOR CODE BLOCK
h i.e. BYTES $B_{TT(h)-2}$ and $B_{TT(h)-1}$
ARE CODE BYTES OF CODE WORD

IF ELECT VERTICAL CODING FOR DATA BYTES
OF ARRAY ONLY AND NOT CODE BYTES OF
ROWS.

(END)

# FIG. 5b

FLOWCHART ILLUSTRATION OF A PROCESS OF ENCODING A DATA BLOCK BUNDLE OF THE
FORMAT ILLUSTRATED IN FIGURE 2 (i.e. MODE 2 BUNDLE CODING)

PROCESS EACH DATABLOCK ACCORDING TO
FIGURE 3 TO PRODUCE ENCODED (HORIZONTAL)
DATA BLOCKS AND ARRANGE BLOCKS
ACCORDING TO FIGURE 2; THEN PERFORM
VERTICAL CODING AS FOLLOWS:

INTERPRETATION NOTES:
AS FOR FIGURE 5 BUT WHERE $B_i$ REPRESENTS
DATA BYTES OF THE ARRAY, "i" GOING FROM
0 TO [TT(h-2)]-3 AS SHOWN IN FIGURE 2. THE
REGISTER $Z_i$ COMPRISES h-2 BYTES.

VERTICAL CODING

$TT \leftarrow 28$      $TT \leftarrow N = 28$ (NO. OF BYTES PER BLOCK)

$C \leftarrow 0$

$V \leftarrow C$

$i \leftarrow 0$

$Z_i \leftarrow B_v$      $Z_i \leftarrow$ VALUE OF DATA BYTE IN VERTICAL DATA BLOCK

$i \leftarrow i+1$

$V \leftarrow V+TT$

N   is $V = (h-2)TT$ ?   Y

PROCESS VERTICAL DATA BYTES ACCORDING
TO FIGURE 3 BUT LET N=h AND LET $Z_0$ TO
$Z_{h-3}$ TAKE THE PLACE OF $B_0$ TO $B_{N-3}$; SET
$B_{(h-2)}TT$ EQUAL TO $B_{N-2}$ PRODUCED BY
THE PROCESS OF FIGURE 3 AND $B_{(h-1)}TT$
EQUAL TO $B_{N-1}$ PRODUCED BY THE PROCESS
OF FIGURE 3

$C \leftarrow C+1$

N   is $C = TT-2$ ?   Y

PROCESS CODE BYTES ACCORDING TO FIGURE
3 TO PRODUCE A CODE WORD FOR CODE
BLOCKS h-1 AND h i.e. BYTES $B_{TT(h-1)-2}$,
$B_{TT(h-1)-1}$ AND, $B_{TT(h)-2}$, $B_{TT(h)-1}$, resp.

END

FIG. 6

FLOWCHART ILLUSTRATION OF A PROCESS OF DECODING A DATA BLOCK BUNDLE ENCODED
ACCORDING TO THE PROCESS OF FIGURE 5 (i.e. MODE 1 BUNDLE CODING)

PROCESS EACH HORIZONTAL DATA BLOCK OF
THE BUNDLE ACCORDING TO FIGURE 4 TO
DECODE EACH HORIZONTAL DATA BLOCK
ACCORDING TO CODE C. THEN PERFORM
DECODING OF VERTICAL DATA BLOCKS AS
FOLLOWS:

INTERPRETATION NOTES:
AS FOR FIGURE 5 BUT REGISTER Z COMPRISES
2h BYTES;

( VERTICAL DECODING )

$SH \leftarrow 13$

ONLY COLUMNS OF DATA BYTES ARE ENCODED

$TT \leftarrow 28$

$TT \leftarrow N = 28$ (NO. OF BYTES PER BLOCK)

$C \leftarrow 0$

$V \leftarrow C$

$i \leftarrow 0$

$Z_i \leftarrow B_V$

$Z_i \leftarrow$ VALUE OF BYTE IN VERTICAL DATA
BLOCK, 1ST COLUMN OF BLOCK

$i \leftarrow i+1$

$i \leftarrow i+1$

$Z_i \leftarrow B_{V+SH}$

$Z_i \leftarrow$ VALUE OF BYTE IN VERTICAL DATA
BLOCK, 2ND COLUMN OF BLOCK.

$V \leftarrow V+TT$

is
$V = (h)TT+C$
?
N          Y

PROCESS VERTICAL DATA BYTES ACCORDING TO FIGURE 4
BUT LET $N = 2h$ AND LET $Z_0$ TO $Z_{2h-1}$ TAKE THE PLACE OF
$B_0$ TO $B_{N-1}$. ERRONEOUS BYTES THEREBY CORRECTED
CORRESPOND TO BYTES OF THE BUNDLE ACCORDING TO:
$j = C+TT$ (INTEGER $j/2$) + SH ($j$ MODULO 2)
(or, $K = C + TT$ (INTEGER $K/2$) + SH ($K$ MODULO 2))

$C \leftarrow C+1$

is
$C = SH$
?
N          Y

( END )

FIG. 7

FLOWCHART ILLUSTRATION OF A PROCESS OF DECODING A DATA BLOCK BUNDLE ENCODED
ACCORDING TO THE PROCESS OF FIGURE 6 (i.e. MODE 2 BUNDLE CODING)

PROCESS EACH HORIZONTAL DATA BLOCK OF
THE BUNDLE ACCORDING TO FIGURE 4 TO
DECODE EACH HORIZONTAL DATA BLOCK
ACCORDING TO CODE C. THEN PERFORM
DECODING OF VERTICAL DATA BLOCKS AS
FOLLOWS:

INTERPRETATION NOTES:
AS FOR FIGURE 6 BUT REGISTER Z COMPRISES
h BYTES.

VERTICAL  DECODING

$TT \leftarrow 28$

$TT \leftarrow N = 28$ (NO. OF BYTES PER BLOCK)

$C \leftarrow O$

$V \leftarrow C$

$i \leftarrow O$

$Z_i \leftarrow B_V$

$Z_i \leftarrow$ VALUE OF DATA BYTE OR CODE BYTE IN
VERTICAL DATA BLOCK.

$V \leftarrow V + TT$

$i \leftarrow i + I$

is
$V = (h) TT$
?
N

Y

PROCESS VERTICAL DATA BYTES ACCORDING
TO FIGURE 4 BUT LET $N = h$ AND LET $Z_0$ to
$Z_{h-1}$ TAKE THE PLACE OF $B_0$ TO $B_{N-1}$.

ERRONEOUS BYTES, THEREBY CORRECTED
CORRESPOND TO BYTES OF THE BUNDLE
ACCORDING TO:
$j = C + TTj$
(or, $K = C + TTK$)

$C \leftarrow C + 1$

is
$C = TT - 2$
?
N

Y

END

FIG. 8